# EUROPÄISCHE PATENTSCHRIFT

(11) **EP 2 269 221 B1**
(45) Veröffentlichungstag und Bekanntmachung des Hinweises auf die Patenterteilung: **08.03.2017**
(21) Anmeldenummer: 09724749.8
(22) Anmeldetag: 23.01.2009
(51) Int. Cl.: H01L 27/146, H01L 31/0216, H01L 31/0304

(54) **OPTOELEKTRONISCHER STRAHLUNGSDETEKTOR UND VERFAHREN ZUR HERSTELLUNG EINER MEHRZAHL VON DETEKTORELEMENTEN**
OPTOELECTRONIC RADIATION DETECTOR AND METHOD FOR PRODUCING A PLURALITY OF DETECTOR ELEMENTS
DÉTECTEUR DE RAYONNEMENT OPTOÉLECTRONIQUE ET PROCÉDÉ DE FABRICATION D'UNE PLURALITÉ D'ÉLÉMENTS DE DÉTECTION

(30) Priorität: 28.03.2008 DE 102008016100
(43) Veröffentlichungstag der Anmeldung: 05.01.2011
(73) Patentinhaber: OSRAM Opto Semiconductors GmbH, 93055 Regensburg (DE)
(72) Erfinder: WIRTH, Ralph, 93098 Mintraching - Auhof (DE); BUTENDEICH, Rainer, 93059 Regensburg (DE)
(74) Vertreter: Epping - Hermann - Fischer
(86) Internationale Anmeldenummer: PCT/DE2009/000084
(87) Internationale Veröffentlichungsnummer: WO 2009/117977

(56) Entgegenhaltungen:
- EP-A- 1 521 069
- EP-A- 1 643 565
- DE-A1-102004 037 020
- DE-A1-102005 043 918
- DE-A1-102005 061 206

## Beschreibung

Die Erfindung betrifft einen optoelektronischen Strahlungsdetektor sowie ein Verfahren zur Herstellung einer Mehrzahl von Detektorelementen.

Ein optoelektronischer Strahlungsdetektor mit einer spektralen Empfindlichkeitsverteilung gemäß derjenigen des menschlichen Auges ist beispielsweise aus der Offenlegungsschrift WO 2005/096394 A1 bekannt. Ein Strahlungsdetektor ist auch in der Druckschrift DE 10 2005 043 918 A1 beschrieben. Auch in der Druckschrift EP 1 643 565 A2 ist ein Strahlungsdetektor angegeben, der eine Mehrzahl von Detektorelementen aufweist.

Eine Aufgabe der Erfindung ist es, einen vereinfacht herstellbaren Strahlungsdetektor, insbesondere einen vereinfacht herstellbaren und zugleich vielseitig einsetzbaren Strahlungsdetektor, anzugeben.

Diese Aufgabe wird durch die Gegenstände der unabhängigen Patentansprüche gelöst. Vorteilhafte Ausgestaltungen und Weiterbildungen sind Gegenstand der abhängigen Patentansprüche.

Erfindungsgemäß wird ein optoelektronischer Strahlungsdetektor entsprechend Anspruch 1 offenbart, der eine Mehrzahl von Detektorelementen zur Signalerzeugung aufweist, wobei die Detektorelemente jeweils eine spektrale Empfindlichkeitsverteilung haben. Ein Detektorelement weist ein Basisdetektorelement auf, wobei die spektrale Empfindlichkeitsverteilung des Basisdetektorelements eine untere Grenzwellenlänge hat, wobei für Wellenlängen kleiner der unteren Grenzwellenlänge das Detektorelement kein signifikantes Signal mehr liefert. Ein anderes Detektorelement umfasst eine Filterschichtstruktur mit zumindest einer Filterschicht, wobei die Empfindlichkeitsverteilung des anderen Detektorelements ein Maximum bei einer Maximumswellenlänge aufweist. Die spektrale Empfindlichkeitsverteilung des Basisdetektorelements überdeckt die spektrale Empfindlichkeitsverteilung des anderen Detektorelements vollständig. Dabei ist die Filterschichtstruktur derart ausgebildet ist, dass die Filterschichtstruktur Strahlung mit Wellenlängen kleiner als die Maximumswellenlänge und größer als die untere Grenzwellenlänge absorbiert. Das Detektorelement und das andere Detektorelement sind ferner lateral nebeneinander auf einem gemeinsamen Träger angeordnet und jedes Detektorelement weist einen Kontakt auf. Das Detektorelement hat einen Rest einer Filterschicht oder einer Mehrzahl von Filterschichten der Filterschichtstruktur des anderen Detektorelements, wobei der Rest der Filterschicht bzw. der Filterschichten so zwischen dem Kontakt und dem Träger angeordnet ist, dass der Kontakt des Detektorelements und der Kontakt des anderen Detektorelements auf gleicher Höhe über dem Träger angebracht sind. Eine Detektionsfläche des Detektorelements ist von der Filterschicht beziehungsweise den Filterschichten frei, so dass Strahlung ungehindert von der Filterschicht beziehungsweise den Filterschichten in das Detektorelement eintreten kann.

Erfindungsgemäß umfasst das Verfahren zur Herstellung einer Mehrzahl von Detektorelementen mehrere Schritte entsprechend Anspruch 11. In einem Schritt wird eine Halbleiterschichtstruktur für die Detektorelemente bereitgestellt, wobei die Halbleiterschichtstruktur eine Filterschichtstruktur mit zumindest einer Filterschicht und einen aktiven Bereich aufweist, und wobei die Halbleiterschichtstruktur auf einem Träger angeordnet ist. In einem weiteren Schritt wird die Filterschicht entfernt und eine Detektionsfläche für ein Detektorelement freigelegt, wobei die Filterschicht für ein anderes Detektorelement teilweise in der Halbleiterschichtstruktur belassen wird, so dass die Filterschicht zwischen einer Detektionsfläche für das andere Detektorelement und dem aktiven Bereich angeordnet ist.

In einem Schritt wird die Halbleiterschichtstruktur in voneinander getrennte, lateral nebeneinander angeordnete Detektorelemente, die auf dem gemeinsamen Träger angeordnet sind, unterteilt. Schließlich werden die Detektorelemente durch Aufbringen von Kontakten auf die von dem Träger abgewandten Seiten der Detektorelemente und durch Aufbringen eines Gegenkontakts auf dem Träger fertiggestellt.

Gemäß zumindest einer Ausführungsform weist der optoelektronische Strahlungsdetektor eine Mehrzahl von Detektorelementen zur Signalerzeugung auf. In verschiedenen Detektorelementen erzeugte Signale sind bevorzugt voneinander getrennt abgreifbar. Die Detektorelemente können mit verschiedenen spektralen Empfindlichkeitsverteilungen ausgebildet sein. Die spektrale Empfindlichkeitsverteilung eines Detektorelements kann über die Abhängigkeit des im Detektorelement erzeugten Signals, z. B. des Fotostroms oder einer davon abgeleiteten Größe, von der Wellenlänge der auf das Detektorelement einfallenden Strahlung bestimmt werden.

Die Detektorelemente weisen zweckmäßigerweise jeweils eine spektrale Empfindlichkeitsverteilung auf. Bevorzugt weisen verschiedene Detektorelemente verschiedene spektrale Empfindlichkeitsverteilungen auf. Zwei Detektorelemente können insbesondere zur Detektion von Strahlung in voneinander verschiedenen Wellenlängenbereichen ausgebildet sein.

Bevorzugt weist die spektrale Empfindlichkeitsverteilung des jeweiligen Detektorelements eine obere und/oder eine untere Grenzwellenlänge auf.

Die obere (untere) Grenzwellenlänge ist dabei die Wellenlänge, ab der das jeweilige Detektorelement für größere (kleinere) Wellenlängen kein signifikantes Signal mehr liefert, z. B. ein nicht mehr von einem Hintergrundrauschen unterscheidbares Signal. Der Empfindlichkeitsbereich des jeweiligen Detektorelements ist bevorzugt durch das Intervall zwischen unterer und oberer Grenzwellenlänge bestimmt. Die Detektorelemente können also verschiedene Empfindlichkeitsbereiche aufweisen.

Gemäß zumindest einer weiteren Ausführungsform weist ein Detektorelement ein Basisdetektorelement auf. Die spektrale Empfindlichkeitsverteilung des Basisdetektorelements kann eine obere Grenzwellenlänge und/oder eine untere Grenzwellenlänge aufweisen. Das Basisdetektorelement weist bevorzugt einen Empfindlichkeitsbereich auf, der größer ist als der zumindest eines Detektorelements oder der einer Mehrzahl von Detektorelementen des Strahlungsdetektors. Gemäß zumindest einer weiteren Ausführungsform weist ein Detektorelement eine Filterschichtstruktur mit zumindest einer Filterschicht auf. Mittels der Filterschichtstruktur kann eine untere Grenzwellenlänge der Empfindlichkeitsverteilung des Detektorelements bestimmt werden. Die untere Grenzwellenlänge kann dabei einer Bandlücke der Filterschicht entsprechen. Die Filterschichtstruktur kann ein Halbleitermaterial enthalten.

Ein anderes Detektorelement - also ein zusätzliches Detektorelement zu dem Detektorelement, welches das Basisdetektorelement aufweist - weist die Filterschichtstruktur auf.

Gemäß zumindest einer weiteren Ausführungsform weist die spektrale Empfindlichkeitsverteilung eines Detektorelements, insbesondere die des anderen Detektorelements und/oder die des Basisdetektorelements, ein Maximum, z.B. ein globales Maximum, bei einer Maximumswellenlänge auf. Insbesondere kann die Empfindlichkeitsverteilung des jeweiligen Detektorelements des Strahlungsdetektors ein Maximum bei einer jeweiligen Maximumswellenlänge aufweisen. Verschiedene Detektorelemente können bei jeweils verschiedenen Maximumswellenlängen das jeweilige Maximum aufweisen.

Gemäß zumindest einer weiteren Ausführungsform ist die obere Grenzwellenlänge der Empfindlichkeitsverteilung des anderen Detektorelements gleich der oberen Grenzwellenlänge der spektralen Empfindlichkeitsverteilung des Basisdetektorelements.

Gemäß zumindest einer weiteren Ausführungsform ist die Filterschichtstruktur des anderen Detektorelements derart ausgebildet, dass die Filterschichtstruktur Strahlung mit Wellenlängen kleiner der oberen Grenzwellenlänge und/oder größer der unteren Grenzwellenlänge der spektralen Empfindlichkeitsverteilung des Basisdetektorelements absorbiert. Mittels der Filterschichtstruktur kann ein Empfindlichkeitskanal für das andere Detektorelement innerhalb des Empfindlichkeitsbereichs des Basisdetektorelements ausgebildet werden. Insbesondere kann ein Empfindlichkeitsbereich für das andere Detektorelement aus einem demgegenüber breitbandigeren Empfindlichkeitsbereich des Basisdetektorelements mittels der Filterschichtstruktur ausgebildet werden.

Gemäß zumindest einer weiteren Ausführungsform bildet die spektrale Empfindlichkeitsverteilung des anderen Detektorelements einen Empfindlichkeitskanal innerhalb der Empfindlichkeitsverteilung des Basisdetektorelements.

Gemäß zumindest einer weiteren Ausführungsform überdeckt die spektrale Empfindlichkeitsverteilung des Basisdetektorelements diejenige des anderen Detektorelements vollständig.

Gemäß zumindest einer weiteren Ausführungsform ist die Maximumswellenlänge der Empfindlichkeitsverteilung des Basisdetektorelements kleiner als die Maximumswellenlänge der spektralen Empfindlichkeitsverteilung des anderen Detektorelements.

Gemäß zumindest einer weiteren Ausführungsform ist die Filterschichtstruktur derart ausgebildet, dass die Filterschichtstruktur Strahlung mit Wellenlängen kleiner als die Maximumswellenlänge der Empfindlichkeitsverteilung des anderen Detektorelements und vorzugsweise größer als die untere Grenzwellenlänge der Empfindlichkeitsverteilung des Basisdetektorelements absorbiert. Der Empfindlichkeitsbereich - das Intervall zwischen der oberen und der unteren Grenzwellenlänge der Empfindlichkeitsverteilung - des anderen Detektorelements kann daher verglichen mit dem Empfindlichkeitsbereich des Basisdetektorelements schmaler ausgeführt sein. Insbesondere kann der Empfindlichkeitsbereich des anderen Detektorelements innerhalb des Empfindlichkeitsbereichs des Basisdetektorelements liegen.

Gemäß zumindest einer weiteren Ausführungsform ist die Maximumswellenlänge der Empfindlichkeitsverteilung eines Detektorelements, insbesondere die des anderen Detektorelements, kleiner als die obere Grenzwellenlänge der Empfindlichkeitsverteilung des Basisdetektorelements.

Gemäß zumindest einer weiteren Ausführungsform ist die Maximumswellenlänge der Empfindlichkeitsverteilung eines Detektorelements, insbesondere die des anderen Detektorelements, größer als die untere Grenzwellenlänge der spektralen Empfindlichkeitsverteilung des Basisdetektorelements.

Gemäß zumindest einer weiteren Ausführungsform ist die spektrale Empfindlichkeitsverteilung des Strahlungsdetektors durch die spektrale Empfindlichkeitsverteilung der einzelnen Detektorelemente gebildet. Insbesondere kann die spektrale Empfindlichkeitsverteilung des Strahlungsdetektors durch die des Basisdetektorelements und die spektrale Empfindlichkeitsverteilung eines oder einer Mehrzahl von weiteren Detektorelementen, z.B. zwei oder mehr weiteren Detektorelementen, gebildet sein.

Gemäß zumindest einer weiteren Ausführungsform ist ein Detektorelement als Basisdetektorelement ausgebildet. Dieses Detektorelement erzeugt demnach ein Signal gemäß der Empfindlichkeitsverteilung des Basisdetektorelements. Das Basisdetektorelement kann einen vorteilhaft breiten Empfindlichkeitsbereich aufweisen.

Gemäß zumindest einer weiteren Ausführungsform erstreckt sich der spektrale Empfindlichkeitsbereich des Basisdetektorelements über den sichtbaren, den infraroten und/oder den ultravioletten Spektralbereich. Der Strahlungsdetektor bzw. das Basisdetektorelement kann im ultravioletten, im sichtbaren und/oder im infraroten Spektralbereich empfindlich sein.

Gemäß zumindest einer weiteren Ausführungsform weist das andere Detektorelement - also jenes mit der Filterschichtstruktur - auch das Basisdetektorelement auf. Zweckmäßigerweise ist die Filterschichtstruktur zusätzlich zu dem Basisdetektorelement vorgesehen. Durch die Filterschichtstruktur kann aus dem Empfindlichkeitsbereich des Basisdetektorelements durch Absorption von Strahlung in der Filterschichtstruktur vor der Signalerzeugung der Empfindlichkeitsbereich des anderen Detektorelements aus demjenigen des Basisdetektorelements ausgewählt werden. Die Filterschichtstruktur ist dem Basisdetektorelement des anderen Detektorelements vorzugsweise vorgeordnet.

Gemäß zumindest einer weiteren Ausführungsform weist der optoelektronische Strahlungsdetektor eine Mehrzahl von gesonderten Detektorelementen auf. Durch das Vorsehen von gesonderten Detektorelementen kann ein Übersprechen zwischen verschiedenen Detektorelementen gemindert oder vermieden werden.

Gemäß zumindest einer weiteren Ausführungsform ist der Strahlungsdetektor als Strahlungsdetektorchip ausgebildet. Ein Chip ist gegenüber einer Einzelfertigung gesonderter Detektorelemente vereinfacht herstellbar. Der Strahlungsdetektor kann monolithisch integriert ausgebildet sein.

Gemäß zumindest einer weiteren Ausführungsform sind die Detektorelemente nebeneinander angeordnet. Die Detektorelemente können nebeneinander auf einem gemeinsamen Träger, z.B. einem Substrat des Detektorchips, angeordnet oder ausgebildet sein. Dies vereinfacht die Fertigung des Strahlungsdetektors gegenüber einer aufwendig zu realisierenden Anordnung der Detektorelemente übereinander.

Gemäß zumindest einer weiteren Ausführungsform weisen die Detektorelemente jeweils einen Halbleiterkörper mit einem zur Signalerzeugung vorgesehenen aktiven Bereich auf. Der Träger, auf dem die Halbleiterkörper angeordnet sind, kann beispielsweise aus dem Aufwachssubstrat, auf dem Halbleiterschichten des Halbleiterkörpers epitaktisch gewachsen sind, gebildet oder gefertigt sein. Im aktiven Bereich absorbierte Strahlung kann über im aktiven Bereich durch Absorption erzeugte Elektronen-Loch-Paare zum Signal des jeweiligen Detektorelements beitragen.

Gemäß zumindest einer weiteren Ausführungsform weisen das Detektorelement, welches das Basisdetektorelement aufweist, und das andere Detektorelement, welches insbesondere die Filterschichtstruktur aufweist, gleichartige aktive Bereiche auf. Insbesondere kann eine Mehrzahl von Detektorelementen des Strahlungsdetektors gleichartige aktive Bereiche aufweisen. Gleichartige aktive Bereiche können gleiche Materialien, die gleiche Zusammensetzung, den gleichen strukturellen Aufbau und/oder die gleiche Dicke aufweisen. Das Basisdetektorelement und das andere Detektorelement können gleichartige aktive Bereiche aufweisen.

Gemäß zumindest einer weiteren Ausführungsform weist der Halbleiterkörper des anderen Detektorelements zusätzlich zum aktiven Bereich die Filterschichtstruktur auf.

Gemäß zumindest einer weiteren Ausführungsform ist der aktive Bereich, die Filterschichtstruktur und/oder der Halbleiterkörper des jeweiligen Detektorelements epitaktisch gewachsen. Die Filterschichtstruktur kann insbesondere in den Halbleiterkörper des jeweiligen Detektorelements integriert, zum Beispiel monolithisch integriert, sein. Das Basisdetektorelement kann im Halbleiterkörper integriert, zum Beispiel monolithisch integriert, sein. Das Basisdetektorelement kann den aktiven Bereich eines oder einer Mehrzahl von Detektorelementen umfassen.

Gemäß zumindest einer weiteren Ausführungsform weist ein Detektorelement, vorzugsweise weist das jeweilige Detektorelement, eine Detektionsfläche auf. Als Detektionsfläche ist jene Fläche des Detektorelements anzusehen, über welche Strahlung in das Detektorelement gelangt. Die Detektionsfläche kann beispielsweise durch eine (Teil)Oberfläche des jeweiligen Halbleiterkörpers gebildet sein. Bevorzugt wird die Detektionsfläche des Detektorelements, welches das Basisdetektorelement aufweist, durch das Basisdetektorelement gebildet. Die Detektionsfläche des anderen Detektorelements, welches die Filterschichtstruktur aufweist, wird zweckmäßigerweise durch die Filterschichtstruktur gebildet. Die Filterschichtstruktur kann insbesondere zwischen dem aktiven Bereich und der Detektionsfläche des anderen Detektorelements angeordnet sein.

Gemäß zumindest einer weiteren Ausführungsform ist ein Teil des anderen Detektorelements, also des Detektorelements, welches die Filterschichtstruktur aufweist, gemäß dem Basisdetektorelement ausgeführt und die Filterschichtstruktur ist, insbesondere im Vergleich zu dem Detektorelement, zusätzlich zu dem Teil des anderen Detektorelements, der gemäß dem Basisdetektor ausgeführt ist, zwischen der Detektionsfläche des anderen Detektorelements und dem aktiven Bereich des anderen Detektorelements angeordnet.

In einer besonders vorteilhaften Ausführungsform weist ein optoelektronischer Strahlungsdetektor eine Mehrzahl von Detektorelementen zur Signalerzeugung auf. Die Detektorelemente weisen jeweils eine spektrale Empfindlichkeitsverteilung auf und ein Detektorelement weist das Basisdetektorelement auf. Die spektrale Empfindlichkeitsverteilung des Basisdetektorelements weist eine untere Grenzwellenlänge auf und ein anderes Detektorelement weist eine Filterschichtstruktur mit zumindest einer Filterschicht auf. Die Empfindlichkeitsverteilung des anderen Detektorelements weist ein Maximum bei einer Maximumswellenlänge auf, und die Filterschichtstruktur ist derart ausgebildet ist, dass die Filterschichtstruktur Strahlung mit Wellenlängen kleiner als die Maximumswellenlänge der Empfindlichkeitsverteilung des anderen Detektorelements und größer als die untere Grenzwellenlänge der Empfindlichkeitsverteilung des Basisdetektorelements absorbiert.

Ein derartiger Strahlungsdetektor ist vereinfacht herstellbar und insbesondere vielseitig einsetzbar.

Gemäß zumindest einer Ausführungsform eines Verfahrens zur Herstellung einer Mehrzahl von Detektorelementen wird zunächst eine Halbleiterschichtstruktur für die Detektorelemente bereitgestellt, wobei die Halbleiterschichtstruktur eine Filterschichtstruktur mit zumindest einer Filterschicht und einen aktiven Bereich, der insbesondere zur Signalerzeugung vorgesehen ist, aufweist.

Nachfolgend kann die Filterschicht entfernt und es kann, insbesondere durch das Entfernen der Filterschicht, eine Detektionsfläche für ein Detektorelement freigelegt werden. Dabei kann die Detektionsfläche vor dem Entfernen von der Filterschicht bedeckt gewesen sein.

Die Filterschicht wird für ein anderes Detektorelement teilweise in der Halbleiterschichtstruktur belassen, so dass die Filterschicht zwischen einer Detektionsfläche für das andere Detektorelement und dem aktiven Bereich angeordnet ist. Die Filterschicht wird also nur bereichsweise entfernt.

Daraufhin können die Detektorelemente fertig gestellt werden.

Das Verfahren ist zur Herstellung eines weiter oben beschriebenen Strahlungsdetektors, insbesondere eines Strahlungsdetektorchips, mit einer Mehrzahl von Detektorelementen besonders geeignet, so dass weiter oben und im Folgenden sich auf den Strahlungsdetektor beziehende Merkmale auch für das Verfahren herangezogen werden können und umgekehrt.

Im Rahmen des Verfahrens kann also eine einzige Halbleiterschichtstruktur für die Fertigung eines Strahlungsdetektors mit unterschiedlichen Detektorelementen, welche insbesondere verschiedene Empfindlichkeitsverteilungen aufweisen können, verwendet werden. Die Filterschichtstruktur ist dabei zweckmäßigerweise derart ausgebildet, dass sie aus der Empfindlichkeitsverteilung, welche durch den aktiven Bereich bestimmt sein kann, einen Empfindlichkeitsbereich für das andere Detektorelement herausschneidet.

Die Halbleiterschichtstruktur kann vor oder nach dem Entfernen der Filterschicht in eine Mehrzahl von, vorzugsweise voneinander getrennten, Halbleiterkörpern unterteilt werden. Dabei wird die Halbleiterschichtstruktur zweckmäßigerweise derart unterteilt, dass ein Halbleiterkörper die Detektionsfläche für das Detektorelement und ein anderer Halbleiterkörper die Detektionsfläche für das andere Detektorelement aufweist und/oder umfasst.

Gemäß zumindest einer weiteren Ausführungsform wird die Halbleiterschichtstruktur vor dem Bereitstellen epitaktisch auf einem Aufwachssubstrat gewachsen. Die Halbleiterschichtstruktur kann beim Bereitstellen auf dem Aufwachssubstrat angeordnet sein.

Gemäß zumindest einer weiteren Ausführungsform wird die Filterschicht mittels Ätzen, insbesondere nasschemischem Ätzen, entfernt. Für das bereichsweise Entfernen der Filterschicht wird vorzugsweise eine geeignet strukturierte Maske, z.B. eine Photolackmaske, eingesetzt.

Gemäß zumindest einer weiteren Ausführungsform sind die Filterschicht und eine Schicht der Halbleiterschichtstruktur, die für die Ausbildung der Detektionsfläche des Detektorelements vorgesehen ist, selektiv ätzbar. Dabei sind die Schichten zweckmäßigerweise derart ausgebildet und aufeinander abgestimmt, dass ein Ätzmittel die Filterschicht angreift und entfernt, während die für die Detektionsfläche vorgesehene Schicht verglichen mit der Filterschicht dem Ätzmittel widersteht. Die für die Detektionsfläche vorgesehene Schicht kann also als Ätzstoppschicht ausgebildet sein.

Mittels selektivem, insbesondere nasschemischem Ätzen, können über der Detektionsfläche des Detektorelements in der Halbleiterschichtstruktur angeordnete Halbleiterschichten auf einfache Weise entfernt werden.

Gemäß zumindest einer weiteren Ausführungsform weist das Basisdetektorelement eine spektrale Empfindlichkeitsverteilung gemäß der spektralen Empfindlichkeitsverteilung des menschlichen Auges auf. Das Basisdetektorelement kann also als Detektorelement mit einer gemäß der Empfindlichkeitsverteilung des menschlichen Auges geformten Empfindlichkeitsverteilung ausgeführt sein. Für die Empfindlichkeitsverteilung des helladaptierten oder dunkeladaptierten menschlichen Auges können die entsprechenden Normen der CIE (Commission Internationale de l'Éclairage) herangezogen werden.

Gemäß zumindest einer weiteren Ausführungsform weist der aktive Bereich eines Detektorelements, insbesondere des jeweiligen Detektorelements, eine Mehrzahl von Funktionsschichten unterschiedlicher Bandlücke und/oder Dicke auf. Durch eine derartige Ausbildung des aktiven Bereichs kann die langwellige Flanke der Empfindlichkeitsverteilung des Basisdetektorelements gemäß einer vorgegebenen Empfindlichkeitsverteilung, z.B. der des Auges, geformt werden. Dabei wird das Signal im aktiven Bereich durch die Mehrzahl von Funktionsschichten gemäß der vorgegebenen Verteilung erzeugt. Auf Filter zur Anpassung der langwelligen Seite der Empfindlichkeit kann mit Vorteil verzichtet werden. Der aktive Bereich absorbiert bevorzugt Strahlung mit Wellenlängen größer der Maximumswellenlänge der Empfindlichkeitsverteilung des Basisdetektorelements.

Gemäß zumindest einer weiteren Ausführungsform weist das Basisdetektorelement, insbesondere zusätzlich zum aktiven Bereich, eine Basisfilterschicht auf. Die Basisfilterschicht absorbiert bevorzugt Strahlung mit Wellenlängen kleiner der Maximumswellenlänge der spektralen Empfindlichkeitsverteilung des Basisdetektorelements. Die Basisfilterschicht kann im Halbleiterkörper integriert sein. Die Basisfilterschicht kann durch Absorption von Wellenlängen kleiner der Maximumswellenlänge der Empfindlichkeitsverteilung des Basisdetektorelements die kurzwellige Flanke dieser Verteilung gemäß einer vorgegebenen Empfindlichkeitsverteilung formen.

Weist das Basisdetektorelement beispielsweise eine Empfindlichkeitsverteilung gemäß derjenigen des menschlichen Auges auf, so ist eine geeignete Ausbildung des Basisdetektorelements in der Druckschrift WO 2005/096394 A1 beschrieben, deren gesamter Offenbarungsgehalt hiermit explizit durch Rückbezug in die vorliegende Patentanmeldung aufgenommen wird.

Gemäß zumindest einer weiteren Ausführungsform weist ein Detektorelement einen Rest einer oder einer Mehrzahl von Filterschichten der Filterschichtstruktur auf, wobei die Detektionsfläche dieses Detektorelements von der Filterschicht bzw. den Filterschichten frei ist, so dass Strahlung ungehindert von der Filterschicht bzw. den Filterschichten in das Detektorelement eintreten kann. Die Detektionsfläche, welche von der bzw. den Filterschichten frei ist kann z. B. durch das Basisdetektorelement gebildet sein. Auf dem Filterschichtstrukturrest ist ein elektrischer Anschluss für dieses Detektorelement angeordnet.

Gemäß zumindest einer Ausführungsform ist die Filterschichtstruktur eine passive, also nicht zur Signalerzeugung geeignete, vorgesehene oder ausgebildete Filterschichtstruktur.

Gemäß zumindest einer weiteren Ausführungsform enthält ein Halbleiterkörper eines Detektorelements, bevorzugt enthält der Halbleiterkörper des jeweiligen Detektorelements, insbesondere der aktive Bereich, die Basisfilterschicht und/oder die Filterschichtstruktur, ein Verbindungshalbleitermaterial, vorzugsweise ein III-V-Halbleitermaterial. III-V-Halbleitermaterialien zeichnen sich durch vorteilhaft hohe Quanteneffizienz aus. Insbesondere können auch geeignete Filterschichten mit III-V-Halbleitermaterialien realisiert werden.

Beispielsweise enthält der aktive Bereich InGaAlP. Dieses Material ist zur Signalerzeugung im sichtbaren und/oder ultravioletten Spektralbereich besonders geeignet. Alternativ oder zusätzlich kann der aktive Bereich (Al)GaAs enthalten. (Al)GaAs ist zur Signalerzeugung im infraroten Spektralbereich besonders geeignet.

Die Filterschichtstruktur kann InGaAlP und/oder AlGaAs enthalten.

Gemäß zumindest einer weiteren Ausführungsform weist die Filterschichtstruktur eine Mehrzahl von Filterschichten auf.

Gemäß zumindest einer weiteren Ausführungsform ist ein Halbleiterkörper eines Detektorelements, bevorzugt ist der Halbleiterkörper des jeweiligen Detektorelements, gemäß einer pin-Diodenstruktur ausgebildet. Derartige Diodenstrukturen zeichnen sich durch vorteilhaft geringe Ansprechzeiten aus.

Gemäß zumindest einer weiteren Ausführungsform ist der aktive Bereich, insbesondere sind die Funktionsschichten, intrinsisch, also undotiert, ausgeführt.

Gemäß zumindest einer weiteren Ausführungsform ist die Filterschichtstruktur dotiert ausgeführt. Auf der Filterschichtstruktur oder einem Rest der Filterschichtstruktur kann so vereinfacht ein Anschluss des jeweiligen Detektorelements angeordnet werden.

Gemäß zumindest einer weiteren Ausführungsform weist der Strahlungsdetektor zusätzlich zu dem Detektorelement, welches das Basisdetektorelement aufweist, als erstem Detektorelement und dem anderen Detektorelement, welches die Filterschichtstruktur aufweist, als zweitem Detektorelement ein drittes Detektorelement auf. Das dritte Detektorelement weist zweckmäßigerweise eine Filterschichtstruktur mit zumindest einer Filterschicht auf. Die spektrale Empfindlichkeitsverteilung des dritten Detektorelements weist bevorzugt ein Maximum bei einer Maximumswellenlänge auf. Die Filterschichtstruktur des dritten Detektorelements ist bevorzugt derart ausgebildet, dass die Filterschichtstruktur Strahlung mit Wellenlängen kleiner als die Maximumswellenlänge der Empfindlichkeitsverteilung des dritten Detektorelements und/oder größer als die untere Grenzwellenlänge der Empfindlichkeitsverteilung des Basisdetektorelements absorbiert.

Bevorzugt absorbiert die Filterschichtstruktur des dritten Detektorelements Strahlung mit Wellenlängen größer der Maximumswellenlänge der Empfindlichkeitsverteilung des Basisdetektorelements und/oder größer der Maximumswellenlänge der Empfindlichkeitsverteilung des zweiten Detektorelements.

Gemäß zumindest einer weiteren Ausführungsform weist die Filterschichtstruktur des dritten Detektorelements eine Mehrzahl von Filterschichten auf. Zwei Filterschichten, insbesondere zwei aneinander grenzende Filterschichten, der Filterschichtstruktur des dritten Detektorelements sind vorzugsweise selektiv ätzbar, insbesondere selektiv nasschemisch ätzbar, ausgebildet. Die Filterschichtstruktur des dritten Detektorelements kann eine der Filterschicht des zweiten Detektorelements entsprechende Filterschicht, insbesondere eine Filterschicht gleicher Zusammensetzung und/oder Dicke, und eine zusätzliche Filterschicht aufweisen.

Die zusätzliche Filterschicht des dritten Detektorelements absorbiert bevorzugt Strahlung mit Wellenlängen größer der Maximumswellenlänge der Empfindlichkeitsverteilung des zweiten Detektorelements und besonders bevorzugt Wellenlängen kleiner der oberen Grenzwellenlänge der Empfindlichkeitsverteilung des Basisdetektorelements.

Mittels des dritten Detektorelements kann ein weiterer Empfindlichkeitsbereich aus der Empfindlichkeitsverteilung des Basisdetektorelements erhalten werden.

Die zusätzliche Filterschicht des dritten Detektorelements ist bevorzugt auf der vom aktiven Bereich abgewandten Seite der Filterschicht des dritten Detektorelements angeordnet.

Gemäß zumindest einer weiteren Ausführungsform ist das dritte Detektorelement gemäß dem zweiten Detektorelement unter Hinzufügung der zusätzlichen Filterschicht ausgebildet.

Gemäß zumindest einer weiteren Ausführungsform sind die Filterschicht und die zusätzliche Filterschicht selektiv ätzbar, insbesondere selektiv nasschemisch ätzbar, ausgebildet.

Gemäß zumindest einer weiteren Ausführungsform sind die Filterschicht und die Basisfilterschicht selektiv ätzbar, insbesondere selektiv nasschemisch ätzbar, ausgebildet.

Eine Filterschichtenfolge, welche bevorzugt die Basisfilterschicht, die Filterschicht und/oder die zusätzliche Filterschicht aufweist, kann beispielsweise alternierend eine (Al)GaAs enthaltende und eine InGaAlP enthaltende Schicht aufweisen. Eine Halbleiterschicht, die (Al)GaAs oder InGaAlP enthält, ist gegenüber einer weiteren Halbleiterschicht, die InGaAlP bzw. (Al)GaAs enthält - also einer Schicht mit dem jeweils anderen Material -, selektiv ätzbar.

Gemäß zumindest einer weiteren Ausführungsform ist der Strahlungsdetektor sowohl als Umgebungslichtdetektor mit einer spektralen Empfindlichkeitsverteilung gemäß der spektralen Empfindlichkeitsverteilung des menschlichen Auges als auch als Farbsensor, insbesondere zur Detektion und/oder Unterscheidung dreier Grundfarben, betreibbar. Die einzelnen Farbkanäle, z.B. zum Erfassen dreier Grundfarben, für den Betrieb als Farbsensor können mittels Differenzbildung der aus einzelnen Detektorelementen erhaltenen Signale erhalten werden.

Gemäß zumindest einer weiteren Ausführungsform ist der Strahlungsdetektor gleichzeitig als Umgebungslichtdetektor mit einer spektralen Empfindlichkeitsverteilung gemäß der spektralen Empfindlichkeitsverteilung des menschlichen Auges und als Farbsensor, insbesondere zur Detektion und/oder Unterscheidung dreier Grundfarben, betreibbar.

Weitere Merkmale, Vorteile und Zweckmäßigkeiten ergeben sich aus der folgenden Beschreibung der Ausführungsbeispiele in Verbindung mit den Figuren.
Figur 1 zeigt anhand der Figuren 1A, 1B und 1C verschiedene schematische Ansichten eines Ausführungsbeispiels eines optoelektronischen Strahlungsdetektors und anhand von Figur 1D eine schematische Schnittansicht eines Teils eines Detektorelements des Strahlungsdetektors.
Figur 2 zeigt in Figur 2A spektrale Empfindlichkeitsverteilungen der Detektorelemente und in Figur 2B aus diesen erhaltene Farbkanäle.
Figur 3 zeigt eine schematische Aufsicht auf ein weiteres Ausführungsbeispiel eines Strahlungsdetektors.
Figur 4 zeigt ein Ausführungsbeispiel eines Verfahrens zur Herstellung eines Strahlungsdetektors anhand von in den Figuren 4A, 4B, 4C, 4D und 4E schematisch dargestellten Zwischenschritten.

Gleiche, gleichartige und gleich wirkende Elemente sind in den Figuren mit gleichen Bezugszeichen versehen.

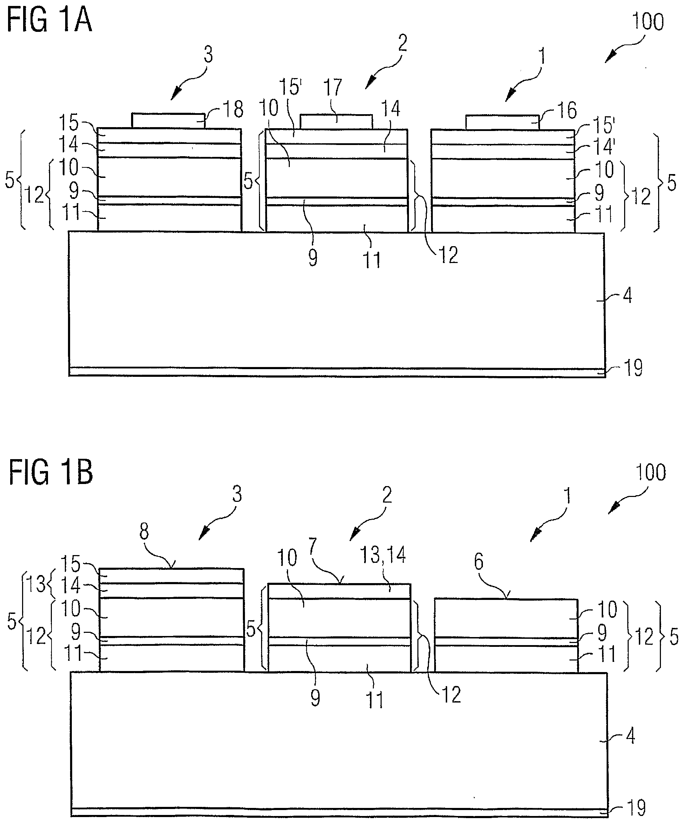

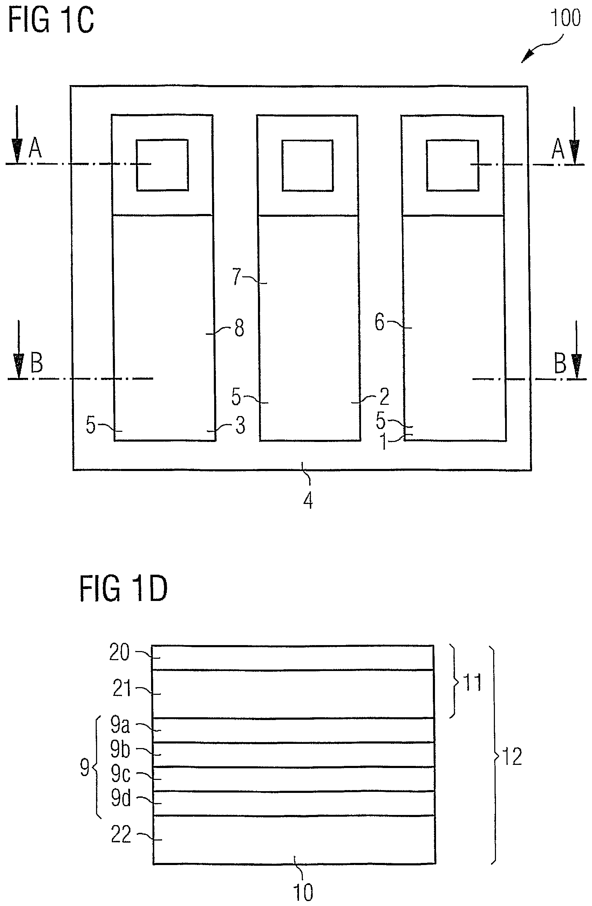

Figur 1 zeigt anhand der Figuren 1A, 1B und 1C verschiedene schematische Ansichten eines Ausführungsbeispiels eines optoelektronischen Strahlungsdetektors. Figur 1D zeigt eine schematische Schnittansicht eines Teils eines Detektorelements des Strahlungsdetektors.

Figur 1C zeigt eine schematische Aufsicht auf den Strahlungsdetektor, Figur 1A eine schematische Schnittansicht entlang der Linie A-A und Figur 1B eine Schnittansicht entlang der Linie B-B in Figur 1C.

Der Strahlungsdetektor 100 weist eine Mehrzahl von Detektorelementen 1, 2, 3 auf. In diesem Ausführungsbeispiel umfasst der Strahlungsdetektor drei Detektorelemente. Alternativ können jedoch auch zwei oder mehr als drei Detektorelemente, zum Beispiel vier oder mehr oder fünf oder mehr, vorgesehen sein. Die Detektorelemente sind nebeneinander auf einem Träger 4 des Strahlungsdetektors angeordnet. Die Detektorelemente 1, 2, 3 sind auf einer gemeinsamen Oberfläche des Trägers 4 angeordnet.

Die Detektorelemente 1, 2, 3 weisen jeweils einen Halbleiterkörper 5 auf. Der Halbleiterkörper 5 kann jeweils epitaktisch gewachsen sein. Insbesondere kann der Träger 4 aus dem Aufwachssubstrat für Epitaxieschichten des Halbleiterkörpers gebildet sein.

Der Strahlungsdetektor 100 kann insgesamt als Strahlungsdetektorchip ausgeführt sein. Die Detektorelemente sind vorzugsweise monolithisch integriert ausgeführt. Insbesondere kann der Strahlungsdetektor auf einfache Weise gefertigt werden. Der Strahlungsdetektor kann im Verbund gefertigt werden, das heißt es können eine Mehrzahl von Strahlungsdetektoren gleichzeitig hergestellt werden, wobei einzelne Strahlungsdetektoren durch Vereinzeln aus dem Verbund erhalten werden.

Die Detektorelemente 1, 2, 3 weisen jeweils eine Detektionsfläche 6, 7, 8 auf. Die Detektionsfläche des jeweiligen Detektorelements ist zweckmäßigerweise von dem Träger 4 abgewandt. Weiterhin ist die Detektionsfläche für den Strahlungseintritt von vom Strahlungsdetektor 100 zu detektierender Strahlung in das jeweilige Detektorelement vorgesehen. Die jeweilige Detektionsfläche 6, 7, 8 ist mittels einer Oberfläche des Halbleiterkörpers 5 des jeweiligen Detektorelements, insbesondere einer vom Träger abgewandten Oberfläche des jeweiligen Halbleiterkörpers, gebildet. Die Detektorelemente 1, 2, 3 weisen weiterhin jeweils einen zur Signalerzeugung vorgesehenen aktiven Bereich 9 auf. Der aktive Bereich 9 kann im Halbleiterkörper 5 vorgesehen sein. Der aktive Bereich 9 ist vorzugsweise intrinsisch, insbesondere undotiert, ausgeführt. Der jeweilige Halbleiterkörper weist weiterhin bevorzugt zwei Halbleiterbereiche 10 und 11 auf. Die Halbleiterbereiche 10 und 11 sind vorzugsweise für unterschiedliche Leitungstypen (n-leitend oder p-leitend) dotiert ausgeführt. Der Halbleiterbereich 10 kann zum Beispiel p-leitend und der Halbleiterbereich 11 n-leitend ausgebildet sein. Der jeweilige Halbleiterbereich 10 beziehungsweise 11 kann eine oder eine Mehrzahl von Halbleiterschichten aufweisen.

Der Halbleiterkörper 5 des jeweiligen Detektorelements kann also eine pin-Diodenstruktur aufweisen. Derartige Diodenstrukturen zeichnen sich durch vorteilhaft geringe Ansprechzeiten aus.

Über die Detektionsflächen 6, 7, 8 in den Halbleiterkörper 5 des jeweiligen Detektorelements 1, 2 beziehungsweise 3 eintretende Strahlung kann zum aktiven Bereich 9 des jeweiligen Detektorelements gelangen, dort absorbiert werden und ein Elektron-Loch-Paar erzeugen. Die im aktiven Bereich erzeugten Ladungsträger können zu einem Signal des jeweiligen Detektorelements beitragen.

Die aktiven Bereiche 9 der Detektorelemente 1, 2, 3 können dabei gleichartig, insbesondere gleich ausgeführt sein. Die aktiven Bereiche 9 können aus einer einzigen epitaktisch gewachsenen Schicht oder Schichtstruktur ausgebildet sein.

Die Detektorelemente 6, 7, 8 können weiterhin jeweils ein Basisdetektorelement 12 aufweisen. Das Basisdetektorelement 12 kann im jeweiligen Halbleiterkörper integriert sein. Die Detektorelemente sind vorzugsweise zur Detektion von Strahlung in verschiedenen Empfindlichkeitsbereichen ausgebildet. Das Basisdetektorelement weist vorzugsweise einen breiten Empfindlichkeitsbereich auf. Der spektrale Empfindlichkeitsbereich des Basisdetektorelements kann sich über den sichtbaren Spektralbereich erstrecken, zum Beispiel von einschließlich 410 nm bis zu und einschließlich 680 nm. Für das Ausbilden verschiedener Empfindlichkeitsbereiche der Detektorelemente aus dem Empfindlichkeitsbereich des Basisdetektorelements ist dem aktiven Bereich eines Detektorelements eine Filterschicht vorgeordnet, welche Wellenlängen aus der einfallenden Strahlung absorbiert. Dementsprechend werden in dem Wellenlängenbereich, in dem die Filterschicht absorbiert, im aktiven Bereich nur vermindert oder keine Elektron-Loch-Paare und dementsprechend wird kein signifikantes Signal erzeugt.

Die Filterschichtstruktur kann im Halbleiterkörper 5 des jeweiligen Detektorelements 1, 2 beziehungsweise 3 integriert sein.

Eine Filterschichtstruktur mit einer oder einer Mehrzahl von Filterschichten kann insbesondere zwischen der Detektionsfläche des jeweiligen Detektorelements und dem aktiven Bereich dieses Detektorelements angeordnet sein. Im vorliegenden Ausführungsbeispiel weist das Detektorelement 3 eine Filterschichtstruktur 13 mit zwei Filterschichten 14, 15 auf. Das Detektorelement 2 weist eine Filterschichtstruktur 13 mit einer Filterschicht 14 auf. Die Filterschichten 14 des Detektorelements 2 und 3 können dabei gleich ausgeführt sein. Insbesondere können die Filterschichten 14 aus einer einzelnen, epitaktisch gewachsenen Schicht ausgebildet sein. Die Detektionsfläche 7, 8 des jeweiligen Detektorelements 2 bzw. 3 kann durch die vom aktiven Bereich abgewandte Fläche der Filterschichtstruktur 13 gebildet sein. Zwischen der Detektionsfläche 6 und dem aktiven Bereich 9 des Detektorelements 1 ist keine Filterschichtstruktur angeordnet. Die Detektionsfläche 6 wird durch das Basisdetektorelement gebildet. Die spektrale Empfindlichkeitsverteilung des Detektorelements 1 kann somit die des Basisdetektorelements sein.

Die jeweilige Filterschichtstruktur 13 absorbiert bevorzugt Wellenlängen kleiner der oberen Grenzwellenlänge der spektralen Empfindlichkeitsverteilung des Basisdetektorelements. Dabei ist die Filterschicht 15 zweckmäßigerweise für die Absorption größerer Wellenlängen als die Filterschicht 14 ausgebildet. Insbesondere kann die Filterschicht 14 eine größere Bandlücke aufweisen, als die Filterschicht 15.

Die in der jeweiligen Filterschicht zu absorbierenden Wellenlängen können über die Bandlücke dieser Filterschicht eingestellt werden.

Mittels der Filterschichtstruktur 13 können insbesondere Empfindlichkeitskanäle innerhalb der spektralen Empfindlichkeitsverteilung des Basisdetektorelements gebildet werden. Die Filterschichtstruktur dient vorzugsweise nicht der Signalerzeugung und ist insbesondere als passive Filterschichtstruktur ausgebildet.

Für das Erfassen des in dem jeweiligen Detektorelement 1, 2, 3 erzeugten Signals weisen die Detektorelemente jeweils einen Kontakt 16, 17 beziehungsweise 18 auf. Der jeweilige Kontakt kann als Kontaktmetallisierung oder Kontaktlegierung ausgeführt sein. Der jeweilige Kontakt ist auf der vom Träger 4 abgewandten Seite des Detektorelements angeordnet. Zweckmäßigerweise ist der jeweilige Kontakt mit dem aktiven Bereich 9 des entsprechenden Detektorelements elektrisch leitend verbunden. Die elektrisch leitende Anbindung kann beispielsweise durch die Filterschichtstruktur 13 hindurch erfolgen.

Die Filterschichtstruktur 13 und insbesondere die Filterschicht 14 und/oder 15 kann für die elektrische Kontaktierung des aktiven Bereichs 9 dotiert, z.B. p-leitend dotiert, ausgeführt sein. Eine Dicke der Filterschicht 14 und/oder 15 kann 0,8 µm oder mehr, bevorzugt 1,0 µm oder mehr, besonders bevorzugt 1,5 µm oder mehr oder 2 µm oder mehr, betragen.

Auch ein Detektorelement, bei dem die Detektionsfläche frei von einer Filterschicht oder der Filterschichtstruktur ist, kann einen Rest der Filterschicht oder der Filterschichtstruktur eines anderen Detektorelements aufweisen. Der Filterschicht(struktur)rest ist außerhalb der Detektionsfläche vorgesehen. Das Detektorelement 2, weist zusätzlich zur Filterschicht 14 einen Filterschichtrest 15' der Filterschicht 14 auf. Das Detektorelement 1 weist Filterschichtstrukturreste 14' und 15' der Filterschichten 14 bzw. 15 auf (vgl. Figur 1A). Der jeweilige Filterschichtrest 14', 15' ist zwischen dem Kontakt und dem aktiven Bereich des Detektorelements 1 beziehungsweise 2 angeordnet. Das Belassen eines Filterschicht(struktur)rests auch in Detektorelementen, in denen keine Filterung durch die jeweilige Filterschicht gewünscht ist, hat den Vorteil, dass die Kontakte 16, 17, 18 auf gleicher Höhe auf die Halbleiterkörper aufgebracht werden können. Dies vereinfacht die Herstellung des Strahlungsdetektors.

Die Detektorelemente 1, 2, 3 können einen gemeinsamen, zu dem jeweiligen Kontakt 16, 17 beziehungsweise 18 korrespondierenden Gegenkontakt 19 des Strahlungsdetektors aufweisen. Der Gegenkontakt kann beispielsweise auf der vom Träger 4 abgewandten Seite der Detektorelemente angeordnet sein.

Der aktive Bereich 9, der Halbleiterbereich 10, der Halbleiterbereich 11, die Filterschicht 14 und/oder die Filterschicht 15 kann ein Verbindungshalbleitermaterial, insbesondere ein III-V-Verbindungshalbleitermaterial enthalten. Der Halbleiterkörper kann aus Verbindungshalbleitern bestehen.

Als Verbindungshalbleitermaterial ist ein auf Phosphid-Verbindungshalbleitermaterial und/oder ein auf Arsenid-Verbindungshalbleitermaterial basierendes Halbleitermaterial besonders geeignet. Für den aktiven Bereich eignet sich dabei ein Phosphid-Verbindungshalbleitermaterial besonders zur Strahlungsdetektion im ultravioletten und/oder sichtbaren Spektralbereich und ein Arsenid-Verbindungshalbleitermaterial besonders zur Detektion im sichtbaren und/oder infraroten Spektralbereich. Filterschichten mit geeigneten Bandlücken können sowohl auf Arsenid-Basis als auch auf Phosphid-Basis realisiert werden. Dabei ist es besonders zweckmäßig, für die Filterschichten 14 und 15 sowie gegebenenfalls für die seitens des aktiven Bereichs an die Filterschichtstruktur angrenzende Schicht Materialien aus verschiedenen Materialsystemen zu wählen. Insbesondere können Materialien aus verschiedenen Materialsystemen alternierend angeordnet werden. Die Materialsysteme der alternierenden Schichten sind zweckmäßigerweise selektiv ätzbar. Die Fertigung des Strahlungsdetektors wird so vereinfacht.

"Auf Phosphid-Verbindungshalbleitern basierend" bedeutet in diesem Zusammenhang, dass der Halbleiterkörper, insbesondere der aktive Bereich, vorzugsweise AlₙGaₘIn₁₋ₙ₋ₘP umfasst, wobei 0 ≤ n ≤ 1, 0 ≤ m ≤ 1 und n+m ≤ 1 ist, vorzugsweise mit n ≠ 0, m ≠ 0, n ≠ 1 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass der Halbleiterkörper, insbesondere der aktive Bereich, vorzugsweise AlₙGaₘIn₁₋ₙ₋ₘAs umfasst, wobei 0 ≤ n ≤ 1, 0 ≤ m ≤ 1 und n+m ≤ 1 ist, vorzugsweise mit n ≠ 0, m ≠ 0, n ≠ 1 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Halbleiterschichten mit Phosphid-Verbindungshalbleitermaterial und Arsenid-Verbindungshalbleitermaterial können mit Vorteil auf einem gemeinsamen Substrat und insbesondere aufeinander epitaktisch aufgewachsen werden. Es ist besonders zweckmäßig, Materialien aus den Untermaterialsystemen In_{0,5}(Ga₁₋ₓAlₓ)_{0,5}P und AlₓGa₁₋ₓAs, jeweils mit 0 ≤ x ≤ 1 und vorzugsweise x ≠ 0 und/oder x ≠ 1, einzusetzen, da diese bezüglich der Gitterkonstante gut aneinander angepasst sind. Als Aufwachssubstrat eignet sich beispielsweise GaAs.

Über den Al-Gehalt kann die Bandlücke und darüber die in der jeweiligen Schicht zu absorbierende Strahlung eingestellt werden. Bei Phosphid-Verbindungshalbleitermaterialien steigt mit wachsendem Al-Gehalt die Bandlücke. Die absorbierbaren Wellenlängen verringern sich damit mit wachsendem Al-Gehalt. Gleiches gilt für Arsenid-Verbindungshalbleitermaterialien, bei denen die Bandlücke auch mit wachsendem Al-Gehalt steigt.

Der Strahlungsdetektor 100 ist weiterhin vielseitig einsetzbar. Zum einen kann an dem Detektorelement 1 das Signal gemäß dem Basisdetektorelement 12 abgegriffen werden. An den Detektorelementen 2 beziehungsweise 3 kann das Signal entsprechend dem jeweiligen Empfindlichkeitskanal innerhalb des Empfindlichkeitsbereichs des Basisdetektorelements abgegriffen werden. Über geeignete Verfahren zur Verarbeitung der erhaltenen Signale können dabei verschiedene Anwendungen realisiert werden.

Figur 1D zeigt eine schematische Schnittansicht eines Ausführungsbeispiels des Basisdetektorelements 12 aus den Figuren 1A, 1B und 1C.

Das Basisdetektorelement 12 umfasst den aktiven Bereich 9. Der aktive Bereich 9 weist eine Mehrzahl von Funktionsschichten 9a, 9b, 9c und 9d auf. Die Funktionsschichten weisen zweckmäßigerweise unterschiedliche Bandlücken und/oder Dicken auf. Mittels einer Mehrzahl von Funktionsschichten im aktiven Bereich kann die langwellige Flanke der spektralen Empfindlichkeitsverteilung des Basisdetektorelements geformt werden. Dem aktiven Bereich 9 strahlungseintrittsseitig vorgeordnet ist eine Basisfilterschicht 20. Mittels der Basisfilterschicht 20 kann insbesondere die kurzwellige Flanke der spektralen Empfindlichkeitsverteilung des Basisdetektorelements geformt werden. Diese Verteilung weist mit Vorzug ein Maximum bei einer vorgegebenen Maximumswellenlänge auf. Dabei kann die Basisfilterschicht 20 Wellenlängen kleiner der Maximumswellenlänge absorbieren. Eine oder eine Mehrzahl von Funktionsschichten kann Strahlung mit Wellenlängen größer der Maximumswellenlänge absorbieren.

Die Basisfilterschicht 20 enthält bevorzugt ein Material, welches gegenüber dem der Filterschicht 14, welche an die Basisfilterschicht angrenzen kann, selektiv ätzbar ist. Beispielsweise enthält die Basisfilterschicht AlGaAs. Die Filterschicht 14 kann InGaAlP enthalten. Die Filterschicht 15 kann wieder AlGaAs enthalten.

Der Al-Gehalt der Basisfilterschicht 20 ist vorzugsweise größer als der Al-Gehalt der Filterschicht 15, insbesondere dann, wenn beide Schichten AlGaAs enthalten oder daraus bestehen.

Der aktive Bereich 9 des Basisdetektorelements ist vorzugsweise zwischen zwei Mantelschichten 21, 22 angeordnet, die für unterschiedliche Leitungstypen dotiert sein können.

Das Basisdetektorelement 12 ist bevorzugt als Umgebungslichtsensor mit einer spektralen Empfindlichkeitsverteilung gemäß derjenigen des menschlichen Auges ausgebildet.

Eine für den Umgebungslichtsensor besonders geeignete Ausgestaltung der Schichten des Basisdetektorelements ist in der folgenden Tabelle angegeben.

| Schicht | Zusammensetzung | Dicke in nm |
|---|---|---|
| Basisfilterschicht 20 | Al_{0,80}Ga_{0,20}As | 400 |
| Funktionsschicht 9a | (Al_{0,5}Ga_{,0,5})_{0,5}In_{0,5}P | 600 |
| Funktionsschicht 9b | (Al_{0,4}Ga_{0,6})_{0,5}In_{0,5}P | 600 |
| Funktionsschicht 9c | (Al_{0,3}Ga_{0,7})_{0,5}In_{0,5}P | 400 |
| Funktionsschicht 9d | (Al_{0,1}Ga_{0,9})_{0,5}In_{0,5}P | 100 |
| Mantelschicht 21 | AlInP | 300 |
| Mantelschicht 22 | AlInP | 300 |

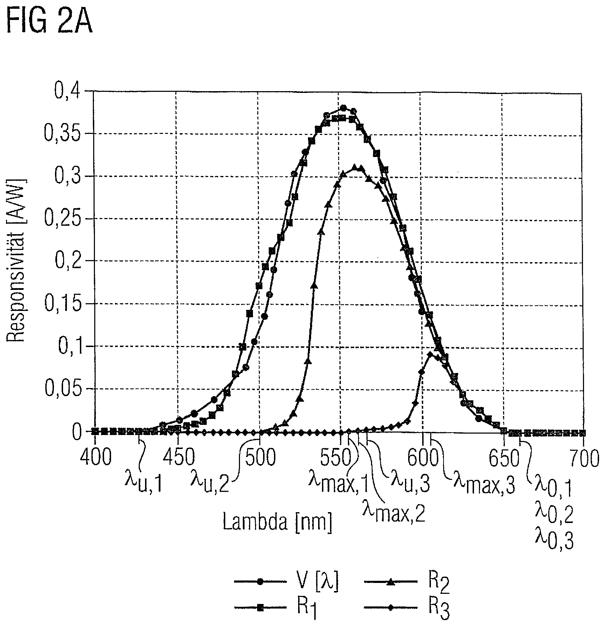

Figur 2A zeigt die spektralen Empfindlichkeitsverteilungen Rᵢ (i = 1, 2, 3) der Detektorelemente 1, 2 beziehungsweise 3 des Strahlungsdetektors. Aufgetragen ist jeweils der erzeugte Signalstrom pro Watt der einfallenden Strahlungsleistung in Abhängigkeit von der Wellenlänge der einfallenden Strahlung. Diese Empfindlichkeitsverteilungen wurden durch eine Simulation gewonnen. Weiterhin ist in Figur 2A die Empfindlichkeitsverteilung V(λ) des helladaptierten menschlichen Auges gemäß der CIE-Norm eingetragen. Der Strahlungsdetektor kann gemäß dem im Zusammenhang mit Figur 1 beschriebenen Ausführungsbeispiel ausgeführt sein.

Das Detektorelement 1 ist als Umgebungslichtsensor ausgeführt und weist eine spektrale Empfindlichkeitsverteilung R₁ gemäß V(λ) auf. Das Basisdetektorelement 12, welches die Detektionsfläche des Detektorelements 1 bildet, kann wie im Zusammenhang mit Figur 1D beschrieben ausgeführt sein.

Das Detektorelement 2 weist gegenüber dem Basisdetektorelement 12 zusätzlich die Filterschicht 14 auf. Diese Filterschicht kann InGaAlP, insbesondere In_{0,5}(Ga_{0,3}Al_{0,7})_{0,5}P oder In_{0,5}(Ga_{0,2}Al_{0,8})_{0,5}P, enthalten oder daraus bestehen. Die Filterschicht 14 kann eine Dicke von 1 µm oder von 2 µm aufweisen. Dabei ist eine Dicke von 1 µm für eine In_{0,5}(Ga_{0,3}Al_{0,7})_{0,5}P-Filterschicht 14 und eine Dicke von 2 µm für eine In_{0,5}(Ga_{0,2}Al_{0,8})_{0,5}P-Filterschicht 14 von besonderem Vorteil.

Die Filterschicht 15, die das Detektorelement 3 gegenüber dem Detektorelement 2 zusätzlich aufweist, kann AlGaAs, insbesondere Al_{0,5}Ga_{0,5}As, enthalten oder daraus bestehen. Die Filterschicht 15 kann eine Dicke von 2 µm aufweisen.

Die Filterschicht 14 absorbiert Strahlung im blauen Spektralbereich. Das Detektorelement 2 ist gegenüber dem Detektorelement 1 somit im blauen Spektralbereich unempfindlicher und kann gegebenenfalls sogar kein signifikantes Signal in diesem Spektralbereich erzeugen. Das Detektorelement 2 zeigt aber im grünen und roten Spektralbereich eine maßgebliche Empfindlichkeit.

Gegenüber dem Detektorelement 2 absorbiert die Filterschicht 15 zusätzlich Strahlung im grünen und orangen Spektralbereich, so dass das Detektorelement 3 im Wesentlichen nur im roten Spektralbereich ein signifikantes Signal liefern kann.

Auf der langwelligen Endseite, für Wellenlängen größer ca. 625 nm, folgen die Empfindlichkeitsverteilungen der Detektorelemente Ri jeweils der des menschlichen Auges V(λ). Insbesondere verlaufen die Verteilungen auf der langwelligen Endseite deckungsgleich. Die kurzwellige Flanke der spektralen Empfindlichkeitsverteilung R₂ wird durch die Filterschicht 14 bestimmt. Die kurzwellige Flanke der Verteilung R₃ wird durch die Filterschichten 14 und 15 bestimmt. Die kurzwellige Flanke der Verteilung R₁ wird durch die Basisfilterschicht 20 bestimmt.

Die Empfindlichkeitsverteilung R₁ des Detektorelements 1, das durch das Basisdetektorelement gebildet ist, weist eine untere Grenzwellenlänge λ_{u,1} auf. Diese liegt bei ungefähr 430 nm. Weiterhin weist die spektrale Empfindlichkeitsverteilung des Basisdetektorelements eine obere Grenzwellenlänge λ_{o,1} auf. Diese liegt zum Beispiel bei ungefähr 660 nm. Die spektrale Empfindlichkeitsverteilung des Basisdetektorelements weist ferner ein Maximum bei λ_{max,1} auf. Diese Wellenlänge liegt für das helladaptierte Auge bei ungefähr 555 nm.

Die spektrale Empfindlichkeitsverteilung R₂ des Detektorelements 2 weist entsprechend eine untere Grenzwellenlänge λ_{u,2} und eine obere Grenzwellenlänge λ_{o,2} sowie insbesondere ein Maximum bei λ_{max,2} auf. Die untere Grenzwellenlänge liegt bei ungefähr 500 nm, die obere Grenzwellenlänge λ_{o,2} ist vorzugsweise gleich der des ersten Detektorelements. Die Maximumswellenlänge λ_{max,2} ist vorzugsweise größer als die des Basisdetektorelements und beträgt zum Beispiel ungefähr 560 nm.

Die Empfindlichkeitsverteilung R₃ des Detektorelements 3 weist entsprechend eine untere Grenzwellenlänge λ_{u,3} und eine obere Grenzwellenlänge λ_{o,3} und insbesondere ein Maximum bei λ_{max,3} auf. Die untere Grenzwellenlänge λ_{u,3} liegt bei ungefähr 565 nm. Die obere Grenzwellenlänge λ_{o,3} ist zweckmäßigerweise gleich derjenigen der beiden anderen Detektorelemente. Die Maximumswellenlänge λ_{max,3} ist ungefähr gleich 610 nm.

λ_{max,i} (i =1,2,3) kann mit wachsender Anzahl an Filterschichten zunehmen (λ_{max,1} < λ_{max,2} < λ_{max,3}).

Die untere Grenzwellenlänge des jeweiligen Empfindlichkeitskanals - also der Verteilungen R₂ bzw. R₃ - kann durch die Bandlücke der Filterschicht 14 beziehungsweise 15 bestimmt sein und insbesondere dieser Bandlücke entsprechen.

Die Filterschicht 14 absorbiert mit Vorzug Wellenlängen kleiner λ_{max,2} und insbesondere größer λ_{u,1}. Die Filterschicht 15 absorbiert bevorzugt Wellenlängen kleiner λ_{max,3} und insbesondere größer λ_{u,1}. Die Filterschicht 15 kann Wellenlängen größer λ_{u,2} absorbieren. Insbesondere kann gelten: λ_{u,1} < λ_{u,2} < λ_{u,3}.

Die spektralen Empfindlichkeitsverteilungen der Detektorelemente 2 und 3 können also Empfindlichkeitskanäle innerhalb der Empfindlichkeitsverteilung des Basisdetektorelements ausbilden. Die Empfindlichkeitsverteilung R₂ kann dabei die Empfindlichkeitsverteilung R₃ vollständig überdecken. Die Empfindlichkeitsverteilung R₁ kann die Empfindlichkeitsverteilung R₂ vollständig überdecken.

Aus den in den einzelnen Detektorelementen erzeugten und getrennt voneinander abgreifbaren Signalen kann Information über die Farbe, insbesondere die Farbanteile, z.B. der drei Grundfarben Rot, Grün und Blau, in einer zu detektierenden Strahlung erhalten werden. Um Information über Farben, welche in einfallender Strahlung enthalten sind, zu erhalten, kann eine Differenz aus in den einzelnen Detektorelementen erzeugten Signalen gebildet werden.

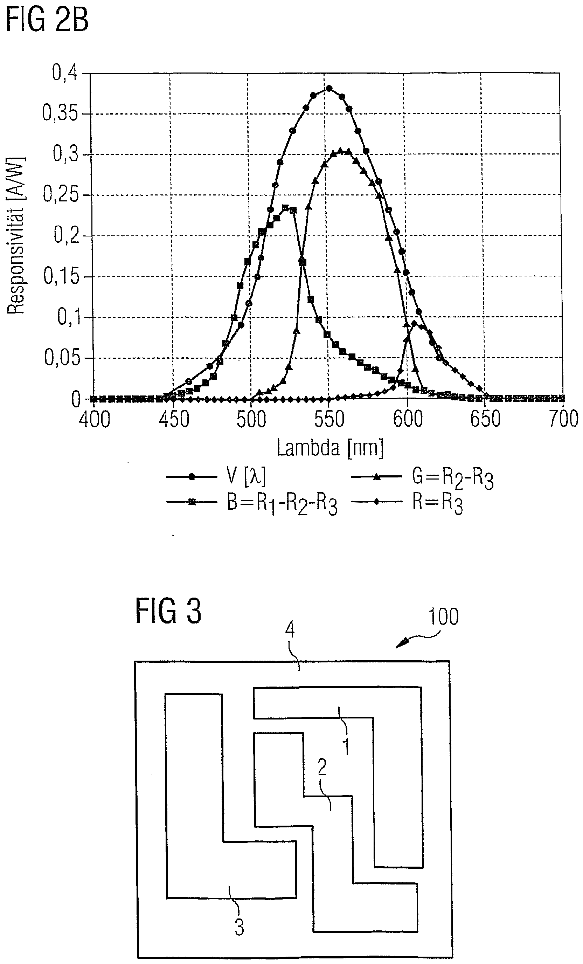

Figur 2B zeigt entsprechend gebildete Differenzen der Empfindlichkeitsverteilungen, welche für das Auslesen der Anteile an den Grundfarben Rot, Grün und Blau in der zu detektierenden Strahlung geeignet sind. Die Kurve R entspricht der Verteilung R₃ und ist für die Farbe Rot vorgesehen. Die Kurve G ist aus der Differenz der Verteilungen R₂ und R₃ erhalten. Die Kurve G ist für Grün vorgesehen. Die Kurve B entspricht der Differenz R₁ - R₂ - R₃. Die Kurve B ist für Blau vorgesehen.

Aus Differenzen von Signalen aus den einzelnen Detektorelementen kann so Aufschluss über Farbanteile in der einfallenden Strahlung erhalten werden. Gleichzeitig kann unabhängig von den Farbanteilen das Signal des Basisdetektorelements also des Detektorelements 1 erfasst werden. Damit kann der Strahlungsdetektor 100 gleichzeitig als Farbsensor und Umgebungslichtsensor betrieben werden.

Es sei noch angemerkt, dass die Anzahl an Detektorelementen nicht auf drei beschränkt ist, vielmehr kann eine größere Anzahl an Detektorelementen vorgesehen sein. Diese dienen vorzugsweise der Detektion in verschiedenen Empfindlichkeitsbereichen. Insbesondere muss das Basisdetektorelement nicht als Umgebungslichtsensor ausgebildet sein. Vielmehr kann das Basisdetektorelement auch im ultravioletten, dem sichtbaren und/oder infraroten Spektralbereich - bei geeigneter Modifikation des aktiven Bereichs und gegebenenfalls der Filterschichtstruktur - ausgebildet sein. Empfindlichkeitskanäle können auch dann mittels geeigneter Filterung aus der Empfindlichkeitsverteilung des Basisdetektorelements erhalten werden.

Dabei entspricht die maximale Anzahl von Filterschichten in einem Detektorelement des Strahlungsdetektors vorzugsweise der Anzahl an aus der Empfindlichkeitsverteilung des Basisdetektorelements auszubildenden Kanälen.

Der im Zusammenhang mit Figur 1 beschriebene Strahlungsdetektor 100 kann streifenförmig verlaufende und nebeneinander auf dem Träger 4 angeordnete Detektorelemente und insbesondere Halbleiterkörper 5 aufweisen. Die Detektorelemente, die verschiedene Empfindlichkeitsbereiche aufweisen, sind auf dem Träger vergleichsweise stark lokalisiert. Daher besteht die Gefahr, dass Strahlung, z.B. aufgrund eines ungünstigen Einfallswinkels, nur auf eines der Detektorelemente trifft und dort ein Signal erzeugt, obwohl diese Strahlung auch in einem anderen Detektorelement ein Signal erzeugen würde. Die Auswertung der Signale würde dann ein verfälschte Ergebnis liefern. Um diese Gefahr zu verringern, kann ein Detektorelement oder es können eine Mehrzahl von Detektorelementen großflächig über den Träger verteilt werden. Beispielsweise können Detektorelemente in Aufsicht auf den Träger eine geknickte, etwa L-förmige Form, aufweisen. Detektorelemente können sich weitläufig über den Träger 4 erstrecken. Detektorelemente können in Aufsicht ineinander eingreifen, so dass zwischen zwei Teilbereichen eines Detektorelements ein Teilbereich eines anderen Detektorelements angeordnet ist.

Eine delokalisierte und insbesondere großflächige Verteilung der Detektorelemente auf dem Träger ist in Figur 3, welche eine schematische Aufsicht auf ein entsprechendes Ausführungsbeispiel eines Strahlungsdetektors 100 zeigt, dargestellt. Bis auf die in Aufsicht andere Formgebung können die Detektorelemente 1, 2, 3 gemäß Figur 1 ausgebildet sein. Auf eine detaillierte Darstellung der Kontakte, der Filterschichten und der Detektionsflächen wurde aus Übersichtlichkeitsgründen verzichtet.

Alternativ oder ergänzend kann eines oder eine Mehrzahl von Detektorelementen in eine Mehrzahl von gesonderten Teildetektorelementen aufgeteilt werden (nicht explizit dargestellt). Die in Teildetektorelementen erzeugten Signale können getrennt voneinander abgegriffen werden oder elektrisch zusammengefasst werden. Im letzteren Fall sind die Teildetektorelemente eines Detektorelements zweckmäßigerweise untereinander elektrisch leitend verbunden. Im ersteren Fall weisen die Teildetektorelemente zweckmäßigerweise gesonderte Kontakte auf.

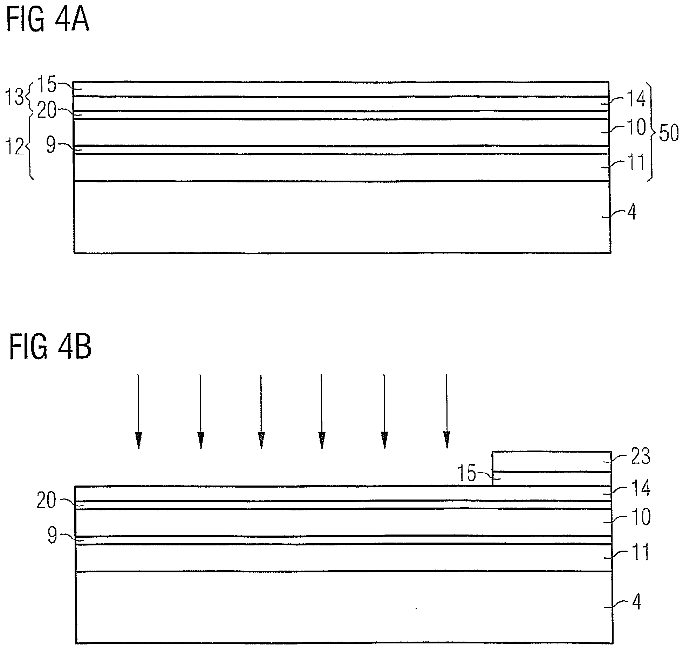

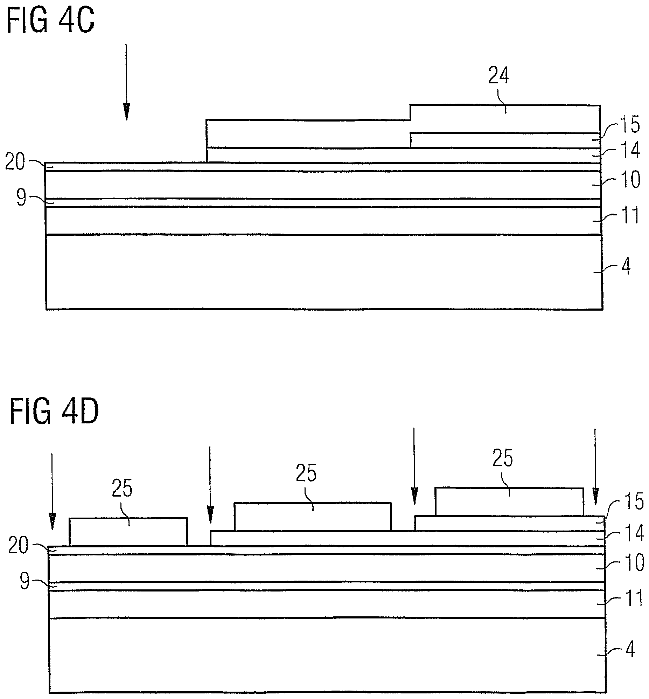

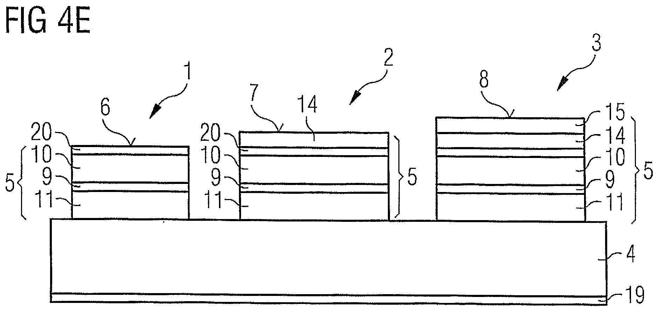

Figur 4 zeigt ein Ausführungsbeispiel eines Verfahrens zur Herstellung eines Strahlungsdetektors, insbesondere eines Strahlungsdetektors gemäß den im Zusammenhang mit den vorhergehenden Figuren beschriebenen Ausführungsbeispielen, anhand von in den Figuren 4A, 4B, 4C, 4D und 4E schematisch dargestellten Zwischenschritten.

Zunächst wird eine Halbleiterschichtstruktur 50 bereitgestellt, Figur 4A. Die Halbleiterschichtstruktur 50 ist auf einem Träger 4 angeordnet. Mit Vorteil stabilisiert der Träger 4 die Halbleiterschichtstruktur 50 mechanisch. Der Träger 4 kann aus dem Aufwachssubstrat, auf dem die Halbleiterschichtstruktur epitaktisch gewachsen wurde, gebildet sein. Der Aufbau der Halbleiterschichtstruktur 50 entspricht dabei bevorzugt dem Aufbau des Detektorelements 3 gemäß Figur 1. Insbesondere weist die Halbleiterschichtstruktur das Basisdetektorelement 12 mit dem aktiven Bereich 9, den Halbleiterbereichen 10, 11 und der Basisfilterschicht 20 auf. Weiterhin weist die Halbleiterschichtstruktur die Filterschicht 14 und die Filterschicht 15 auf. Die Halbleiterschichtstruktur kann also die Filterschichtstruktur 13 mit den beiden Filterschichten 14 und 15 umfassen.

Nachfolgend wird ein Teilbereich der Filterschicht 15 entfernt, Figur 4B. Hierzu wird zum Beispiel auf der der Filterschicht 15 abgewandeten Seite der Halbleiterschichtstruktur eine Maske 23 vorgesehen. Es kann beispielsweise Maskenmaterial auf die Halbleiterschichtstruktur aufgebracht werden und nachfolgend in dem Bereich, in dem die Filterschicht 15 zu entfernen ist wieder entfernt werden. Hierzu eignet sich eine Photolackschicht, welche mittels Belichtung und nachfolgender Entwicklung für die Maske 23 geeignet strukturiert werden kann. Der nicht mit der Maske 23 bedeckte Bereich der Halbleiterschichtstruktur kann nachfolgend entfernt werden. Hierzu eignet sich beispielsweise ein Ätzverfahren, insbesondere nasschemisches Ätzen. Das Ätzmittel ist durch die Pfeile in Figur 4B angedeutet.

Das verwendete Ätzmittel kann dabei das Material der Filterschicht 15 bereichsweise abtragen. Bevorzugt ist das Material der Filterschicht 14, welche zwischen der Filterschicht 15 und dem aktiven Bereich 9 angeordnet ist im Vergleich zu der Filterschicht 15 weniger empfindlich gegenüber dem verwendeten Ätzmittel. Die Filterschicht 14 kann insbesondere als Ätzstoppschicht ausgeführt sein. Hierzu basieren die Filterschichten 14 und 15 vorzugsweise auf unterschiedlichen Halbleitermaterialsystemen. Beispielsweise basiert die Filterschicht 15 auf Arsenid-Verbindungshalbleitermaterial und die Filterschicht 14 auf Phosphid-Verbindungshalbleitermaterial. Die Filterschicht 15 kann AlGaAs und die Filterschicht 14 InGaAlP enthalten oder daraus bestehen.

Für das selektive Ätzen einer AlGaAs-haltigen Filterschicht gegenüber einer InGaAlP-haltigen Filterschicht eignet sich beispielsweise H₂SO₄:H₂O₂:H₂O oder ein ähnliches Ätzmittel. Dabei wird AlGaAs-Material wesentlich stärker angegriffen als InGaAlP-Material.

Der von der Maske bedeckte Bereich der Filterschicht 15 verbleibt für die Detektionsfläche des Detektorelements 3 in der Halbleiterschichtstruktur. Daraufhin kann die Maske 23 wieder entfernt werden.

Nachfolgend kann eine weitere Maske 24, z.B. eine Photolackmaske, auf der verbleibenden Halbleiterschichtstruktur ausgebildet werden, Figur 4C. Die Maske 24 bedeckt vorzugsweise den in der Halbleiterschichtstruktur belassenen Bereich der Filterschicht 15 sowie einen Teilbereich der Filterschicht 14. Die mit der Maske 24 bedeckten Teilbereiche können zur Ausbildung der Detektionsflächen der Detektorelemente 2 und 3 gemäß Figur 1 vorgesehen sein.

Der nicht mit der Maske 24 bedeckte Teilbereich der Filterschicht 14 kann daraufhin, z.B. mittels nasschemischen Ätzens unter Einsatz eines geeigneten Ätzmittels, entfernt werden. Die Basisfilterschicht 20 kann dabei als Ätzstoppschicht dienen. Die Basisfilterschicht 20 enthält zweckmäßigerweise AlGaAs. Daraufhin kann die Maske 24 entfernt werden.

Für das selektive Ätzen einer InGaAlP-haltigen Filterschicht gegenüber einer AlGaAs-haltigen Filterschicht eignet sich beispielsweise HCl. Dabei wird InGaAlP-Material wesentlich stärker angegriffen als AlGaAs-Material.

Der von der Filterschicht 14 befreite Teilbereich der Halbleiterschichtstruktur 50 kann für das Ausbilden der Detektionsfläche des Detektorelements 1 gemäß Figur 1 vorgesehen sein.

Nachfolgend kann eine weitere Maske 25, z.B. eine Photolackmaske, vorgesehen werden, Figur 4D. Die Maske 25 ist vorzugsweise derart strukturiert, dass für die Ausbildung der Detektorelemente des Strahlungsdetektors vorgesehene Bereiche mit dem Maskenmaterial bedeckt sind. Freiliegende Bereiche können daraufhin entfernt werden. Hierzu eignet sich beispielsweise wieder ein Ätzverfahren, wie nasschemisches Ätzen. Hierzu kann gegebenenfalls ein Ätzmittel eingesetzt werden das die Filterschicht 15, die Filterschicht 14 und auch die Basisfilterschicht 20 sowie gegebenenfalls weitere Materialien in der Halbleiterschichtstruktur gleichermaßen angreift.

Die Halbleiterschichtstruktur 50 wird dadurch in voneinander getrennte Halbleiterkörper 5 aufgeteilt, Figur 4E. Die Halbleiterkörper 5 entsprechen jeweils einem Detektorelement 1, 2 beziehungsweise 3 gemäß Figur 1. Alternativ kann das Aufteilen auch vor dem bereichsweisen Entfernen einer der Filterschichten 14, 15 durchgeführt werden.

Weiterhin kann vor oder nach dem Aufteilen in Halbleiterkörper auf die von dem Halbleitermaterial abgewandte Seite des Trägers 4 ein Gegenkontakt 19 aufgebracht werden. Dieser kann zum Beispiel eine Metallisierung oder Metalllegierung umfassen. Die Detektionsflächen 6, 7, 8 können durch die Basisfilterschicht 20, die Filterschicht 14 beziehungsweise die Filterschicht 15 gebildet sein. Auf die vom Träger 4 abgewandte Seite des Halbleitermaterials der Halbleiterschichtstruktur oder der Halbleiterkörper können dann zu einem geeigneten Zeitpunkt noch Kontakte 16, 17, 18 aufgebracht werden (nicht explizit dargestellt, vgl. Figur 1A).

Zweckmäßigerweise wird ein Teilbereich der Filterschichtstruktur, welche die Filterschichten 14 und gegebenenfalls 15 umfasst, auch für die Detektorelemente, bei denen die Detektionsfläche von der jeweiligen Filterschicht befreit ist, belassen (nicht explizit dargestellt, vgl. Figur 1A). Das Aufbringen von Kontakten in gleicher Höhe über dem Träger ist gegenüber einer abgestuften Ausbildung von Kontakten, die bei vollständigem Entfernen der jeweiligen Filterschicht(en) für die Detektorelemente 1 und 2 erforderlich wäre, vereinfacht.

Aus einer einzigen Halbleiterschichtstruktur können so auf einfache Weise über selektives Ätzen Detektorelemente mit verschiedenen Empfindlichkeitsbereichen gefertigt werden.

## Patentansprüche

1. Optoelektronischer Strahlungsdetektor mit einer Mehrzahl von Detektorelementen (1, 2, 3) zur Signalerzeugung,
wobei
die Detektorelemente jeweils eine spektrale Empfindlichkeitsverteilung (R₁, R₂, R₃) aufweisen,
ein Detektorelement (1) ein Basisdetektorelement (12) aufweist,
die spektrale Empfindlichkeitsverteilung des Basisdetektorelements (R₁) eine untere Grenzwellenlänge (λ_{u,1}) aufweist, wobei für Wellenlängen kleiner der unteren Grenzwellenlänge (λ_{u,1}) das Detektorelement (1) kein signifikantes Signal mehr liefert,
ein anderes Detektorelement (2, 3) eine Filterschichtstruktur (13) mit zumindest einer Filterschicht (14, 15) aufweist,
die Empfindlichkeitsverteilung (R₂, R₃) des anderen Detektorelements ein Maximum bei einer Maximumswellenlänge (λ_{max,2}, λ_{max,3}) aufweist, wobei die spektrale Empfindlichkeitsverteilung des Basisdetektorelements (R₁) die spektrale Empfindlichkeitsverteilung des anderen Detektorelements (R₂, R₃) vollständig überdeckt, und wobei die Filterschichtstruktur derart ausgebildet ist, dass die Filterschichtstruktur Strahlung mit Wellenlängen kleiner als die Maximumswellenlänge (λ_{max,2}, λ_{max,3}) und größer als die untere Grenzwellenlänge (λ_{u,1}) absorbiert, wobei die Detektorelemente (1, 2, 3) jeweils einen Halbleiterkörper (5) mit einem zur Signalerzeugung vorgesehenen aktiven Bereich (9) aufweisen und wobei das Detektorelement (1) und das andere Detektorelement (2,3) lateral nebeneinander auf einem gemeinsamen Träger (4) angeordnet sind,
**gekennzeichnet dadurch dass**
jedes Detektorelement (1,2,3) einen Kontakt (16,17,18) aufweist, wobei das Detektorelement (1) einen Rest einer Filterschicht (14, 15) oder einer Mehrzahl von Filterschichten der Filterschichtstruktur (13) des anderen Detektorelements (2, 3) aufweist, wobei der Rest der Filterschicht bzw. der Filterschichten (14, 15) so zwischen dem Kontakt (16) und dem Träger (4) angeordnet ist, dass der Kontakt (16) des Detektorelements (1) und der Kontakt (17, 18) des anderen Detektorelements (2, 3) auf gleicher Höhe über dem Träger (4) angebracht sind, wobei eine Detektionsfläche (6) des Detektorelements (1) von der Filterschicht bzw. den Filterschichten frei ist, so dass Strahlung ungehindert von der Filterschicht bzw. den Filterschichten in das Detektorelement eintreten kann.

2. Strahlungsdetektor nach Anspruch 1,
bei dem die spektrale Empfindlichkeitsverteilung (R₂, R₃) des anderen Detektorelements eine obere Grenzwellenlänge (λ_{o,2}, λ_{o,3}) aufweist und diese obere Grenzwellenlänge gleich der oberen Grenzwellenlänge (λ_{o,1}) der spektralen Empfindlichkeitsverteilung (R₁) des Basisdetektorelements (12) ist.

3. Strahlungsdetektor nach mindestens einem der vorhergehenden Ansprüche,
bei dem das Basisdetektorelement (1) und das andere Detektorelement (2, 3) gleichartige aktive Bereiche (9) aufweisen.

4. Strahlungsdetektor nach mindestens einem der vorhergehenden Ansprüche,
bei dem der aktive Bereich (9), die Filterschichtstruktur (13) und/oder der Halbleiterkörper (5) des jeweiligen Detektorelements (1, 2, 3) epitaktisch gewachsen ist.

5. Strahlungsdetektor nach mindestens einem der vorhergehenden Ansprüche,
bei dem die Filterschichtstruktur (13) in den Halbleiterkörper (5) des anderen Detektorelements (2, 3) integriert ist.

6. Strahlungsdetektor nach mindestens einem der vorhergehenden Ansprüche,
bei dem das Basisdetektorelement (12) in den Halbleiterkörper (5) des Detektorelements (1) integriert ist.

7. Strahlungsdetektor nach mindestens einem der vorhergehenden Ansprüche,
bei dem ein Teil des anderen Detektorelements (2, 3) gemäß dem Basisdetektorelement (12) ausgeführt ist und die Filterschichtstruktur (13) zusätzlich zu dem Teil des anderen Detektorelements, der gemäß dem Basisdetektorelement ausgeführt ist, zwischen einer Detektionsfläche (7, 8) des anderen Detektorelements (2, 3) und dem aktiven Bereich (9) des anderen Detektorelements angeordnet ist.

8. Strahlungsdetektor nach mindestens einem der vorhergehenden Ansprüche,
bei dem der aktive Bereich (9) und/oder die Filterschichtstruktur (13) ein III-V-Halbleitermaterial enthält.

9. Strahlungsdetektor nach mindestens einem der vorhergehenden Ansprüche,
der gleichzeitig sowohl als Umgebungslichtdetektor mit einer spektralen Empfindlichkeitsverteilung gemäß der spektralen Empfindlichkeitsverteilung des menschlichen Auges als auch als Farbsensor betreibbar ist.

10. Verfahren zur Herstellung eines optoelektronischen Strahlungsdetektors mit einer Mehrzahl von Detektorelementen (1, 2, 3) nach einem der vorhergehenden Ansprüche mit den Schritten:
a) Bereitstellen einer Halbleiterschichtstruktur (50) für die Detektorelemente, wobei die Halbleiterschichtstruktur (50) eine Filterschichtstruktur (13) mit zumindest einer Filterschicht (14, 15) und einen aktiven Bereich (9) aufweist und wobei die Halbleiterschichtstruktur (50) auf einem Träger (4) angeordnet ist;
b) Entfernen der Filterschicht (14, 15) und Freilegen einer Detektionsfläche (6) für ein Detektorelement (1), wobei die Filterschicht (14, 15) für ein anderes Detektorelement (2, 3) teilweise in der Halbleiterschichtstruktur (50) belassen wird, so dass die Filterschicht zwischen einer Detektionsfläche (7, 8) für das andere Detektorelement und dem aktiven Bereich angeordnet ist;
c) Unterteilen der Halbleiterschichtstruktur (50) in voneinander getrennte, lateral nebeneinander angeordnete Detektorelemente (1, 2, 3), die auf dem gemeinsamen Träger (4) angeordnet sind,
d) Fertigstellen der Detektorelemente (1,2,3) durch Aufbringen der Kontakte (16,17,18) auf die von dem Träger (4) abgewandten Seiten der Detektorelemente (1,2,3) und durch Aufbringen eines Gegenkontakts (19) auf dem Träger (4).

11. Verfahren nach Anspruch 10,
bei dem die Halbleiterschichtstruktur (50) vor oder nach Schritt b) in eine Mehrzahl von Halbleiterkörpern (5) unterteilt wird, wobei ein Halbleiterkörper die Detektionsfläche (6) für das Detektorelement (1) und ein anderer Halbleiterkörper die Detektionsfläche (7, 8) für das andere Detektorelement umfasst.

12. Verfahren nach Anspruch 10 oder 11,
bei dem die Filterschicht (14, 15) und eine Schicht der Halbleiterschichtstruktur (50), die für die Ausbildung der Detektionsfläche (6) des Detektorelements (1) vorgesehen ist, selektiv ätzbar sind.

## Claims

1. Optoelectronic radiation detector comprising a plurality of detector elements (1, 2, 3) for signal generation, wherein
the detector elements each have a spectral sensitivity distribution (R₁, R₂, R₃),
one detector element (1) has a basic detector element(12),
the spectral sensitivity distribution of the basic detector element (R₁) has a lower limiting wavelength (λ_{u,1}), wherein for wavelengths shorter than the lower limiting wavelength (λ_{u,1}) the detector element (1) no longer supplies a significant signal,
another detector element (2, 3) has a filter layer structure (13) comprising at least one filter layer (14, 15),
the sensitivity distribution (R₂, R₃) of the other detector element has a maximum at a maximum wavelength (λₘₐₓ, ₂, λₘₐₓ, ₃), wherein the spectral sensitivity distribution of the basic detector element (R₁) completely overlaps the spectral sensitivity distribution of the other detector element (R₂, R₃), and wherein the filter layer structure is embodied in such a way that the filter layer structure absorbs radiation having wavelengths shorter than the maximum wavelength (λₘₐₓ, ₂, λₘₐₓ, ₃) and longer than the lower limiting wavelength (λ_{u,1}), wherein
the detector elements (1, 2, 3) each have a semiconductor body (5) comprising an active region (9) provided for signal generation, and wherein the detector element (1) and the other detector element (2, 3) are arranged laterally alongside one another on a common carrier (4),
**characterized in that**
each detector element (1, 2, 3) has a contact (16, 17, 18), wherein the detector element (1) has a residue of a filter layer (14, 15) or of a plurality of filter layers of the filter layer structure (13) of the other detector element (2, 3) wherein the residue of the filter layer or of the filter layers (14, 15) is arranged between the contact (16) and the carrier (4) such that the contact (16) of the detector element (1) and the contact (17, 18) of the other detector element (2, 3) are fitted at the same height above the carrier (4), wherein a detection area (6) of the detector element (1) is free of the filter layer or the filter layers, such that radiation can enter the detector element in a manner unimpeded by the filter layer or the filter layers.

2. Radiation detector according to Claim 1,
wherein the spectral sensitivity distribution (R₂, R₃) of the other detector element has an upper limiting wavelength (λ_{o,2}, λ_{o,3}) and said upper limiting wavelength is equal to the upper limiting wavelength (λ_{o,1}) of the spectral sensitivity distribution (R₁) of the basic detector element (12).

3. Radiation detector according to at least one of the preceding claims,
wherein the basic detector element (1) and the other detector element (2, 3) have active regions (9) of identical type.

4. Radiation detector according to at least one of the preceding claims,
wherein the active region (9), the filter layer structure (13) and/or the semiconductor body (5) of the respective detector element (1, 2, 3) are/is grown epitaxially.

5. Radiation detector according to at least one of the preceding claims,
wherein the filter layer structure (13) is integrated into the semiconductor body (5) of the other detector element (2, 3).

6. Radiation detector according to at least one of the preceding claims,
wherein the basic detector element (12) is integrated into the semiconductor body (5) of the detector element (1).

7. Radiation detector according to at least one of the preceding claims,
wherein a part of the other detector element (2, 3) is embedded in accordance with the basic detector element (12), and the filter layer structure (13) in addition to that part of the other detector element which is embodied in accordance with the basic detector element is arranged between a detector area (7, 8) of the other detector element (2, 3) and the active region (9) of the other detector element.

8. Radiation detector according to at least one of the preceding claims,
wherein the active region (9) and/or the filter layer structure (13) contain(s) a III-V semiconductor material.

9. Radiation detector according to at least one of the preceding claims,
which is operable simultaneously both as an ambient light detector with a spectral sensitivity distribution in accordance with the spectral sensitivity distribution of the human eye and as a colour sensor.

10. Method for producing an optoelectronic radiation detector comprising a plurality of detector elements (1, 2, 3) according to any of the preceding claims, comprising the following steps:
a) providing a semiconductor layer structure (50) for the detector elements, wherein the semiconductor layer structure (50) has a filter layer structure (13) comprising at least one filter layer (14, 15) and an active region (9), and wherein the semiconductor layer structure (50) is arranged on a carrier (4);
b) removing the filter layer (14, 15) and exposing a detection area (6) for one detector element (1), wherein the filter layer (14, 15) for another detector element (2, 3) is left partly in the semiconductor layer structure (50), such that the filter layer is arranged between a detection area (7, 8) for the other detector element and the active region;
c) subdividing the semiconductor layer structure (50) into detector elements (1, 2, 3) which are separated from one another, are arranged laterally alongside one another and are arranged on the common carrier (4),
d) completing the detector elements (1, 2, 3) by applying the contacts (16, 17, 18) to those sides of the detector elements (1, 2, 3) which face away from the carrier (4) and by applying an opposite contact (19) on the carrier (4).

11. Method according to Claim 10,
wherein the semiconductor layer structure (50) is subdivided into a plurality of semiconductor bodies (5) before or after step b), wherein one semiconductor body comprises the detection area (6) for the detector element (1) and another semiconductor body comprises the detection area (7, 8) for the other detector element.

12. Method according to Claim 10 or 11,
wherein the filter layer (14, 15) and a layer of the semiconductor layer structure (50) which is provided for forming the detection area (6) of the detector element (1) are selectively etchable.

## Revendications

1. Détecteur de rayonnement optoélectronique comportant une pluralité d'éléments détecteurs (1, 2, 3) destinés à générer un signal, dans lequel
les éléments détecteurs présentent respectivement une distribution spectrale de sensibilité (R₁, R₂, R₃),
un élément détecteur (1) comporte un élément détecteur de base (12),
la distribution spectrale de sensibilité de l'élément détecteur (R₁) présente une longueur d'onde limite inférieure (λ_{u,1}), dans lequel l'élément détecteur (1) ne délivre plus de signal significatif pour des longueurs d'onde inférieures à la longueur d'onde limite inférieure (λ_{u,1}),
un autre élément détecteur (2, 3) présente une structure de couches filtrantes (3) comportant au moins une couche filtrante (14, 15),
la distribution de sensibilité (R₂, R₃) de l'autre élément détecteur présente un maximum pour une longueur d'onde maximale (λ_{max,2}, λ_{max,3}), dans lequel la distribution spectrale de sensibilité de l'élément détecteur de base (R₁) recouvre entièrement la distribution spectrale de sensibilité de l'autre élément détecteur (R₂, R₃), et dans lequel la structure de couches filtrantes est réalisée de manière à ce que la structure de couches filtrantes absorbe un rayonnement ayant des longueurs d'onde inférieures à la longueur d'onde maximale (λ_{max,2}, λ_{max,3}) et supérieures à la longueur d'onde limite inférieure (λ_{u,1}), dans lequel les éléments détecteurs (1, 2, 3) présentent respectivement un corps à semi-conducteur (5) ayant une région active (9) prévue pour générer un signal et dans lequel l'élément détecteur (1) et l'autre élément détecteur (2, 3) sont disposés côte à côte latéralement sur un support commun (4),
**caractérisé en ce que** chaque élément détecteur (1, 2, 3) présente un contact (16, 17, 18), dans lequel l'élément détecteur (1) comporte un reste d'une couche filtrante (14, 15) ou d'une pluralité de couches filtrantes de la structure de couches filtrantes (13) de l'autre élément détecteur (2, 3), dans lequel le reste de la couche filtrante ou des couches filtrantes (14, 15) est disposé entre le contact (16) et le support (4) de manière à ce que le contact (16) de l'élément détecteur (1) et le contact (17, 18) de l'autre élément détecteur (2, 3) soient placés à une même hauteur sur le support (4), dans lequel une surface de détection (6) de l'élément détecteur (1) est dépourvue de la couche filtrante ou des couches filtrantes de manière à ce qu'un rayonnement puisse pénétrer dans l'élément détecteur sans être bloqué par la couche filtrante ou les couches filtrantes.

2. Détecteur de rayonnement selon la revendication 1, dans lequel la distribution spectrale de sensibilité (R₂, R₃) de l'autre élément détecteur présente une longueur d'onde limite supérieure (λ_{o,2}, λ_{o,3}) et ladite longueur d'onde limite supérieure est identique à la longueur d'onde limite supérieure (λ_{o,1}) de la distribution spectrale de sensibilité (R₁) de l'élément détecteur de base (12).

3. Détecteur de rayonnement selon au moins l'une des revendications précédentes, dans lequel l'élément détecteur de base (1) et l'autre élément détecteur (2, 3) présentent des régions actives (9) du même type.

4. Détecteur de rayonnement selon au moins l'une des revendications précédentes,
dans lequel la région active (9), la structure de couches filtrantes (13) et/ou le corps à semi-conducteur (5) de l'élément détecteur (1, 2, 3) respectif sont formés par croissance épitaxiale.

5. Détecteur de rayonnement selon au moins l'une des revendications précédentes,
dans lequel la structure de couches filtrantes (13) est intégrée au corps à semi-conducteur (5) de l'autre élément détecteur (2, 3).

6. Détecteur de rayonnement selon au moins l'une des revendications précédentes,
dans lequel l'élément détecteur de base (12) est intégré au corps à semi-conducteur (5) de l'élément détecteur (1).

7. Détecteur de rayonnement selon au moins l'une des revendications précédentes,
dans lequel une partie de l'autre élément détecteur (2, 3) est réalisée conformément à l'élément détecteur de base (12) et la structure de couches filtrantes (13), en plus de la partie de l'autre élément détecteur qui est réalisée conformément à l'élément détecteur de base, est disposée entre une surface de détection (7, 8) de l'autre élément détecteur (2, 3) et la région active (9) de l'autre élément détecteur.

8. Détecteur de rayonnement selon au moins l'une des revendications précédentes,
dans lequel la région active (9) et/ou la structure de couches filtrantes (13) contient un matériau semi-conducteur de type III-V.

9. Détecteur de rayonnement selon au moins l'une des revendications précédentes,
pouvant être mis en fonctionnement simultanément aussi bien en tant que détecteur de lumière ambiante ayant une distribution spectrale de sensibilité conforme à la distribution spectrale de sensibilité de l'oeil humain en tant que capteur de couleur.

10. Procédé de fabrication d'un détecteur de rayonnement optoélectronique comportant une pluralité d'éléments détecteurs (1, 2, 3) selon l'une quelconque des revendications précédentes, comprenant les étapes consistant à :
a) fournir une structure de couches semi-conductrices (50) destinée aux élément détecteurs, dans lequel la structure de couches semi-conductrices (50) comporte une structure de couches filtrantes (13) ayant au moins une couche filtrante (14, 15) et une région active (9) et dans lequel la structure de couches semi-conductrices (50) est disposée sur un support (4) ;
b) enlever la couche filtrante (14, 15) et dégager une surface de détection (6) destinée à l'élément détecteur (1), dans lequel la couche filtrante (14, 15) est laissée partiellement dans la structure de couches semi-conductrices (50) pour un autre élément détecteur (2, 3) de manière à ce que la couche filtrante soit disposée entre une surface de détection (7, 8) destinée à l'autre élément de détection et la région active ;
c) subdiviser la structure de couches semi-conductrices (50) en des éléments détecteurs (1, 2, 3) séparés les uns des autres et disposés latéralement côte à côte, qui sont disposés sur le support commun (4), d) achever les éléments détecteurs (1, 2, 3) en plaçant les contacts (16, 17, 18) sur les faces des éléments détecteurs (1, 2, 3) opposées au support (4) et en plaçant un contre-contact (19) sur le support (4).

11. Procédé selon la revendication 10,
dans lequel la structure de couches semi-conductrices (50) est subdivisée en une pluralité de corps semiconducteurs (5) avant ou après l'étape b), dans lequel un corps semi-conducteur comprend la surface de détection (6) destinée à l'élément détecteur (1) et un autre corps semi-conducteur comprend la surface (7, 8) destinée à l'autre élément détecteur.

12. Procédé selon la revendication 10 ou 11,
dans lequel la couche filtrante (14, 15) et une couche de la structure de couches semi-conductrices (50) qui est prévue pour la réalisation de la surface de détection (6) de l'élément détecteur (1), peuvent être gravées sélectivement.
